# EUROPÄISCHE PATENTSCHRIFT

(11) **EP 0 992 068 B1**
(45) Veröffentlichungstag und Bekanntmachung des Hinweises auf die Patenterteilung: **03.09.2003**
(21) Anmeldenummer: 98934869.3
(22) Anmeldetag: 05.06.1998
(51) Int. Cl.: H01L 27/11, H01L 21/8244

(54) **SRAM-ZELLENANORDNUNG UND VERFAHREN ZU DEREN HERSTELLUNG**
SRAM-CELL ASSEMBLY AND METHOD FOR REALISING THE SAME
GROUPEMENT DE CELLULES DE MEMOIRE RAM STATIQUE ET SON PROCEDE DE PRODUCTION

(30) Priorität: 27.06.1997 DE 19727472
(43) Veröffentlichungstag der Anmeldung: 12.04.2000
(73) Patentinhaber: Infineon Technologies AG, 81669 München (DE)
(72) Erfinder: GOEBEL, Bernd, D-81735 München (DE); BERTAGNOLLI, Emmerich, D-80799 München (DE); WILLER, Josef, D-85521 Riemerling (DE); HASLER, Barbara, D-82131 Stockdorf (DE); VON BASSE, Paul-Werner, D-82515 Wolfratshausen (DE)
(74) Vertreter: Kindermann, Peter, Dipl.-Ing.
(86) Internationale Anmeldenummer: DE9801551
(87) Internationale Veröffentlichungsnummer: WO99000847

(56) Entgegenhaltungen:
- DE-A- 4 215 708
- US-A- 5 258 635
- US-A- 5 324 973

## Beschreibung

Die Erfindung betrifft eine SRAM-Zellenanordnung, bei der eine Speicherzelle sechs Transistoren umfaßt.

Eine SRAM-Zellenanordnung ist eine Speicherzellen-Anordnung mit wahlfreiem Zugriff auf gespeicherte Informationen. Im Gegensatz zu einer DRAM-Zellenanordnung, in der die Information in regelmäßigen Zeitabständen aufgefrischt werden muß, wird die Information statisch gespeichert.

In SRAM-Zellenanordnungen werden zunehmend sogenannte 6 T-Speicherzellen eingesetzt. Eine 6 T-Speicherzelle umfaßt vier, als Flip-Flop verschaltete MOS-Transistoren und zwei Auswahltransistoren. Der Flip-Flop ist in einem von zwei stabilen Zuständen. Der Zustand des Flip-Flops stellt eine logische Größe, 0 oder 1, dar. Durch Ansteuerung der Auswahltransistoren über eine Wortleitung können über zwei Bitleitungen sowohl der Zustand bestimmt und damit die Information ausgelesen als auch der Zustand verändert und damit eine neue Information gespeichert werden.

Da von Speichergeneration zu Speichergeneration die Speicherdichte zunimmt, muß die benötigte Fläche der 6 T-Speicherzelle von Generation zu Generation reduziert werden.

In Semiconductor International (Nov. 1996) Seite 19 und 20 wird eine 6T-Speicherzelle vorgestellt, die mit einer Fläche von 55F² herstellbar ist, wobei F die minimale in der jeweiligen Technologie herstellbare Strukturgröße ist. Es werden selbstjustierte, d.h. ohne Einsatz von zu justierenden Masken hergestellte, Kontakte sowie lokale Verbindungen, d.h. Verbindungen, die innerhalb der Zelle liegen, eingesetzt.

Der Erfindung liegt das Problem zugrunde, eine SRAM-Zellenanordnung anzugeben, die als Speicherzellen 6 T-Speicherzellen umfaßt und mit besonders hoher Packungsdichte herstellbar ist. Ferner soll ein Herstellungsverfahren für eine solche SRAM-Zellenanordnung angegeben werden.

Dieses Problem wird gelöst durch eine SRAM-Zellenanordnung gemäß Anspruch 1 sowie ein Verfahren zu deren Herstellung gemaß Anspruch 6. Weitere Ausgestaltungen der Erfindung gehen aus den übrigen Ansprüchen hervor.

Im folgenden werden die Verbindungen zwischen Teilen der Transistoren der erfindungsgemäßen SRAM-Zellenanordnung erläutert: Ein erstes Source/Drain-Gebiet eines ersten Transistors ist mit einem ersten Source/Drain-Gebiet eines zweiten Transistors und einem ersten Spannungsanschluß verbunden. Ein zweites Source/Drain-Gebiet des ersten Transistors ist mit einem ersten Source/Drain-Gebiet eines dritten Transistors, einem ersten Source/Drain-Gebiet eines fünften Transistors, einer Gateelektrode des zweiten Transistors und einer Gateelektrode eines vierten Transistors verbunden. Eine Gateelektrode des ersten Transistors ist mit einem zweiten Source/Drain-Gebiet des zweiten Transistors, einem ersten Source/Drain-Gebiet des vierten Transistors, einer Gateelektrode des dritten Transistors und einem ersten Source/Drain-Gebiet eines sechsten Transistors verbunden. Ein zweites Source/Drain-Gebiet des dritten Transistors ist mit einem zweiten Source/Drain-Gebiet des vierten Transistors und einem zweiten Spannungsanschluß verbunden. Ein zweites Source/Drain-Gebiet des fünften Transistors ist mit einer ersten Bitleitung verbunden. Eine Gateelektrode des fünften Transistors ist mit einer Gateelektrode des sechsten Transistors und mit einer Wortleitung verbunden. Ein zweites Source/Drain-Gebiet des sechsten Transistors ist mit einer zweiten Bitleitung verbunden. Der dritte Transistor und der vierte Transistor sind komplementär zum ersten Transistor, zum zweiten Transistor, zum fünften Transistor und zum sechsten Transistor. Es liegt im Rahmen der Erfindung zur Verbesserung verschiedener Eigenschaften der SRAM-Zellenanordnung zusätzlich zu den sechs Transistoren einer Speicherzelle weitere Bauelemente, wie z.B. Kondensatoren, in die Speicherzelle zu integrieren.

In der erfindungsgemäßen SRAM-Zellenanordnung sind die sechs Transistoren der Speicherzelle als vertikale Transistoren ausgebildet. Dadurch wird die Fläche der Speicherzelle dadurch besonders klein.

Die sechs Transistoren sind an Flanken von streifenförmigen, parallel zueinander verlaufenden Vertiefungen, die als Gräben in einem Substrat realisiert sein können, ausgebildet, wodurch die Dichte der Verbindungen erhöht und die Fläche der Speicherzelle verkleinert wird. Der erste Transistor und der zweite Transistor werden an einer zweiten Flanke eines ersten Grabens, der fünfte Transistor und der sechste Transistor werden an einer zweiten Flanke eines zweiten Grabens und der dritte Transistor und der vierte Transistor werden an einem ersten Flanke eines vierten Grabens angeordnet.

Mit isolierendem Material gefüllte dritte Gräben können als isolierende Strukturen Teile von zueinander komplementären Transistoren voneinander isolieren.

Es ist vorteilhaft, Gateelektroden der sechs Transistoren jeweils als Spacer, der an eine außerhalb der Vertiefungen angeordnete horizontale leitende Struktur angrenzt, auszubilden. Die Struktur, die aus dem Spacer und der horizontalen leitenden Struktur gebildet wird, wird auch als Strap bezeichnet. Dies ermöglicht eine separate Verbindung der Gateelektroden über eine zugehörige horizontale leitende Struktur mit anderen Teilen der Transistoren. Es ist vorteilhaft, zur Erzeugung der horizontalen leitenden Struktur vor der Erzeugung der Gräben eine leitende Schicht zu erzeugen. Dadurch wird der Spacer selbstjustiert mit der horizontalen leitenden Struktur, die aus der leitenden Schicht entsteht, verbunden.

Zur Verkleinerung der Anzahl von Kontakten und damit der Fläche der Speicherzelle ist es vorteilhaft, Kontakte so anzuordnen, daß sie teilweise seitlich mit den horizontalen leitenden Strukturen überlappen.

Zur Erhöhung der Dichte der Verbindungen und damit zur Verkleinerung der Fläche der Speicherzelle ist es vorteilhaft, mehrere Verbindungsebenen, die leitende Strukturen, Bitleitungen und/oder Wortleitungen enthalten, zu verwenden.

Damit entlang der Flanken der Vertiefungen zwischen benachbarten Source/Drain-Gebieten verschiedener Transistoren keine Ströme fließen, können durch schräge Implantation an den Flanken der Vertiefungen zwischen den Transistoren hochdotierte Channel-Stop-Gebiete erzeugt werden. Die Channel-Stop-Gebiete sind von einem Leitfähigkeitstyp dotiert, der entgegengesetzt zu einem Leitfähigkeitstyp der benachbarten Source/Drain-Gebiete ist.

Zur Verbindung benachbarter Source/Drain-Gebiete, die sich bezüglich einer Achse, die senkrecht zu einer Oberfläche des Substrats verläuft, in unterschiedlicher Höhe befinden, ist es vorteilhaft, hochdotierte Diffusionsgebiete zu erzeugen. Die Diffusionsgebiete können durch schräge Implantation an Teilen der Flanken der Vertiefungen erzeugt werden. Die Diffusionsgebiete sind vom Leitfähigkeitstyp der benachbarten Source/Drain-Gebiete dotiert.

Werden Source/Drain-Gebiete nach Erzeugung der Vertiefungen durch Implantation erzeugt, so ist es vorteilhaft, vor der Implantation Flanken der Vertiefungen mit Spacern und Teile der Speicherzelle mit einer vorläufigen Struktur zu versehen, um die Flanken und die Teile der Speicherzelle vor Implantation zu schützen.

Es ist vorteilhaft, die Wortleitung als Spacer entlang einer Flanke einer der Vertiefungen auszubilden. Die erste Bitleitung und die zweite Bitleitung werden quer zu der Wortleitung ausgebildet.

Zur Verkleinerung der Fläche der Speicherzelle ist es vorteilhaft, wenn die fünfte Gateelektrode des fünften Transistors und die sechste Gateelektrode des sechsten Transistors Teile der Wortleitung sind.

Es ist vorteilhaft, entlang der ersten Bitleitung benachbarte Speicherzellen bezüglich einer Achse, die entlang einer Mittellinie einer Vertiefung verläuft, Spiegel symmetrisch zueinander anzuordnen, und zwar derart, daß die Vertiefung von den Speicherzellen geteilt wird. Die Fläche einer Speicherzelle verkleinert sich dadurch.

Es ist vorteilhaft, zueinander komplementäre Transistoren an verschiedenen Vertiefungen auszubilden. Dadurch können Böden der Vertiefungen durchgängig jeweils von einem Leitfähigkeitstyp dotiert werden und gleichzeitig als Source/Drain-Gebiete und als leitende Strukturen verwendet werden.

Es ist vorteilhaft, zwischen einer Vertiefung, an der Transistoren ausgebildet sind, und einer benachbarten Vertiefung, an der komplementäre Transistoren ausgebildet sind, eine erste isolierende Struktur, die z.B. als eine mit isolierendem Material gefüllte Vertiefung realisiert werden kann, anzuordnen.

Es ist vorteilhaft, eine erste leitende Struktur bzw. eine zweite leitende Struktur, die mit einem ersten Spannungsanschluß bzw. mit einem zweiten Spannungsanschluß verbunden sind, jeweils entlang eines Bodens einer Vertiefung in Form eines dotierten Gebietes innerhalb des Substrats auszubilden. Zur Verkleinerung der Fläche der Speicherzelle ist es vorteilhaft, wenn das erste Source/Drain-Gebiet des ersten Transistors und das erste Source/Drain-Gebiet des zweiten Transistors Teile der zweiten leitenden Struktur und das zweite Source/Drain-Gebiet des dritten Transistors und das zweite Source/Drain-Gebiet des vierten Transistors Teile der ersten leitenden Struktur sind.

Zur Erhöhung der Dichte der Verbindungen ist es vorteilhaft, in einer zusätzlichen Verbindungsebene angeordnete leitende Strukturen zu verwenden, die in Form von Spacern an Flanken der Vertiefungen angeordnet sind und Teile von Transistoren verbinden.

Im folgenden werden Ausführungsbeispiele der Erfindung, die in den Figuren dargestellt sind, näher erläutert.
- Figur 1: zeigt einen eine Speicherzelle umfassenden Ausschnitt aus einer Oberfläche eines Substrats. Die Oberfläche ist in horizontale Bereiche und in vertikale, die horizontalen Bereiche überlappende Bereiche unterteilt.
- Figur 2: zeigt einen Querschnitt entlang einer Grenzlinie eines siebten horizontalen Bereichs und eines achten horizontalen Bereichs durch das Substrat, nachdem erste isolierende Strukturen, erste dotierte Wannen, zweite dotierte Wannen, erste Source/Drain-Gebiete von vierten Transistoren, zweite Source/Drain-Gebiete von zweiten Transistoren, zweite Source/Drain-Gebiete von ersten Transistoren, erste Source/Drain-Gebiete von dritten Transistoren, zweite Source/Drain-Gebiete von fünften Transistoren und zweite Source/Drain-Gebiete von sechsten Transistoren erzeugt wurden.

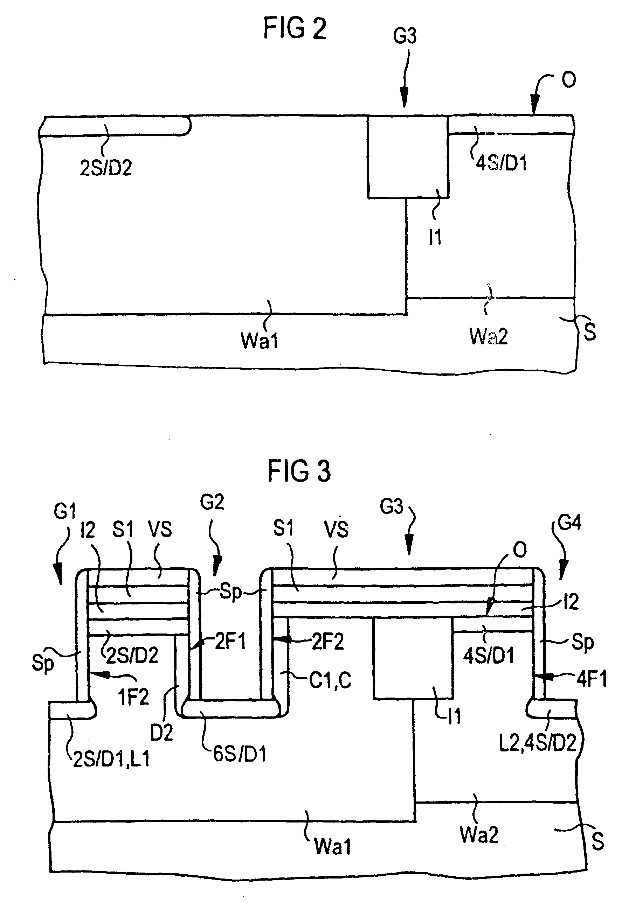

- Figur 3: zeigt den Querschnitt aus Figur 2, nachdem eine zweite isolierende Struktur, eine leitende Schicht, eine vorläufige Struktur, erste Gräben, zweite Gräben, vierte Gräben, Channel/Stop-Gebiete, Diffusionsgebiete, Spacer, erste leitende Strukturen, erste Source/Drain-Gebiete der ersten Transistoren, erste Source/Drain-Gebiet der zweiten Transistoren, erste Source/Drain-Gebiete der fünften Transistoren, erste Source/Drain-Gebiete der sechsten Transistoren, zweite leitende Strukturen, zweite Source/Drain-Gebiete der dritten Transistoren und zweite Source/Drain-Gebiete der vierten Transistoren erzeugt wurden.
- Figur 4: zeigt den Querschnitt aus Figur 3, nachdem ein Gatedielektrikum, Gateelektroden, dritte leitende Strukturen und horizontale leitende Strukturen erzeugt wurden.
- Figur 5: zeigt den Querschnitt aus Figur 4, nachdem zweite Kontakte, vierte Kontakte, fünfte Kontakte, sechste Kontakte, fünfte leitende Strukturen, sechste leitende Strukturen und eine dritte isolierende Struktur erzeugt wurden.
- Figur 6a: zeigt den Querschnitt aus Figur 5, nachdem eine vierte isolierende Struktur, erste Kontakte, dritte Kontakte, siebte Kontakte, achte Kontakte, vierte leitende Strukturen, erste Bitleitungen und zweite Bitleitungen erzeugt wurden.
- Figur 6b: zeigt das Substrat aus Figur 6a in einem zum Querschnitt aus Figur 6a parallelen Querschnitt entlang der einer Grenzlinie zwischen einem dreizehnten horizontalen Bereich und einem vierzehnten horizontalen Bereich.
- Figur 6c: zeigt das Substrat aus Figur 6a in einem zum Querschnitt aus Figur 6a parallelen Querschnitt entlang eines zwölften horizontalen Bereichs.
- Figur 6d: zeigt einen zum Querschnitt aus Figur 6a senkrechten Querschnitt durch das Substrat aus Figur 6a entlang eines dritten vertikalen Bereichs.
- Figur 7a: zeigt den Ausschnitt aus Figur 1, nachdem die ersten isolierenden Strukturen in Form von mit isolierendem Material gefüllten dritten Gräben erzeugt wurden. Auf die Oberfläche wurde eine vierte Maske aufgebracht.
- Figur 7b: zeigt den Ausschnitt aus Figur 7a, nachdem mit Hilfe einer sechsten Maske die ersten Gräben, die zweiten Gräben und die vierten Gräben erzeugt wurden.
- Figur 7c: zeigt den Ausschnitt aus Figur 7b. Auf die Oberfläche wurde eine siebte Maske aufgebracht.
- Figur 7d: zeigt den Ausschnitt aus Figur 7c. Auf die Oberfläche wurde eine achte Maske aufgebracht.
- Figur 7e: zeigt den Ausschnitt aus Figur 7d. Auf die Oberfläche wurde eine elfte Maske aufgebracht.
- Figur 7f: zeigt den Ausschnitt aus Figur 7e. Auf die Oberfläche wurde eine dreizehnte Maske aufgebracht.
- Figur 7g: zeigt den Ausschnitt aus Figur 7f. Auf die Oberfläche wurde eine vierzehnte Maske aufgebracht.
- Figur 7h: zeigt den Ausschnitt aus Figur 7g. Auf die Oberfläche wurde eine sechzehnte Maske aufgebracht.
- Figur 7i: zeigt den Ausschnitt aus Figur 7h. Auf die Oberfläche wurde eine achtzehnte Maske aufgebracht.

Im folgenden bezeichnet die Formulierung "Bereich α bis einschließlich Bereich β" alle Bereiche, die innerhalb einer Speicherzelle zwischen dem Bereich α und dem Bereich β angeordnet sind sowie den Bereich α und den Bereich β. α und β stehen jeweils für eine Zahl oder einen Buchstaben.

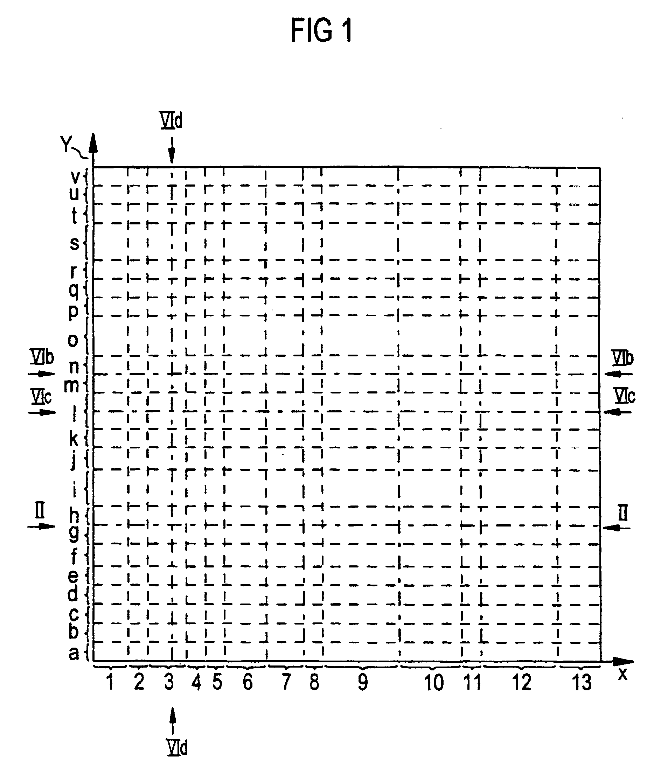

In einem ersten Ausführungsbeispiel ist ein Substrat S eine Scheibe aus Silizium. Eine x-Achse x und eine zur x-Achse x senkrechte y-Achse y verlaufen in einer Oberfläche O des Substrats S (s. Fig 1). Teile der Oberfläche O, an denen jeweils eine Speicherzelle erzeugt wird, sind jeweils in streifenförmige, aneinanderangrenzende, parallel zur x-Achse x verlaufende horizontale Bereiche unterteilt. Die Teile der Oberfläche O werden ebenfalls jeweils in streifenförmige, aneinanderangrenzende, parallel zur y-Achse verlaufende vertikale Bereiche unterteilt (s. Fig 1). In Richtung der x-Achse benachbarte Speicherzellen werden bezüglich parallel zur y-Achse verlaufende Achsen spiegelsymmetrisch zueinander erzeugt: entweder erste vertikale Bereiche 1 oder dreizehnte vertikale Bereiche 13 dieser Speicherzellen grenzen aneinander an. Von jeweils zwei in Richtung der y-Achse zu erzeugenden benachbarten Speicherzellen grenzen ein erster horizontaler Bereich a einer der Speicherzellen und ein zweiundzwanzigster horizontaler Bereich v einer anderen der Speicherzellen aneinander an.

Mit Hilfe einer ersten Maske (nicht dargestellt) aus Fotolack, die in Speicherzellen jeweils den zehnten vertikalen Bereich 10 und den elften vertikalen Bereich 11 nicht bedeckt, werden durch Ätzen von Silizium ca. 500nm tiefe dritte Gräben G3 erzeugt. Als Ätzmittel ist z.B. HBr+NF₃+He+O₂ geeignet. Durch Abscheidung von ***SiO***_{**2**} in einer Dicke von ca. 600nm in einem TEOS-Verfahren und anschließendem Rückätzen werden die dritten Gräben G3 mit ***SiO***_{**2**} gefüllt. Dadurch ententstehen erste isolierende Strukturen I1 (s. Fig 2). Die ersten isolierenden Strukturen I1 sind zur Isolierung von zu erzeugenden Teilen zueinander komplementärer Transistoren voneinander geeignet.

Mit Hilfe einer zweiten Maske (nicht dargestellt) aus Fotolack, die in Speicherzellen jeweils den elften vertikalen Bereich 11 bis einschließlich den dreizehnten vertikalen Bereich 13 bedeckt, werden durch Implantation ca. 2µm tiefe p-dotierte erste Wannen Wa1 erzeugt (s. Fig 2).

Mit Hilfe einer dritten Maske (nicht dargestellt) aus Fotolack, die in Speicherzellen jeweils den elften vertikalen Bereich 11 bis einschließlich den dreizehnten vertikalen Bereich 13 nicht bedeckt, werden durch Implantation ca. 2µm tiefe n-dotierte zweite Wannen Wa2 erzeugt (s. Fig 2). Die ersten isolierenden Strukturen I1 verlaufen damit jeweils zwischen einer ersten Wanne Wa1 und einer zweiten Wanne Wa2. Die ersten Wannen Wa1 und die zweiten Wannen Wa2 sind streifenförmig und verlaufen im wesentlichen parallel zueinander. Die Dotierstoffkonzentrationen der ersten Wannen Wa1 und der zweiten Wannen Wa2 betragen ca. 3*10¹⁷cm⁻³.

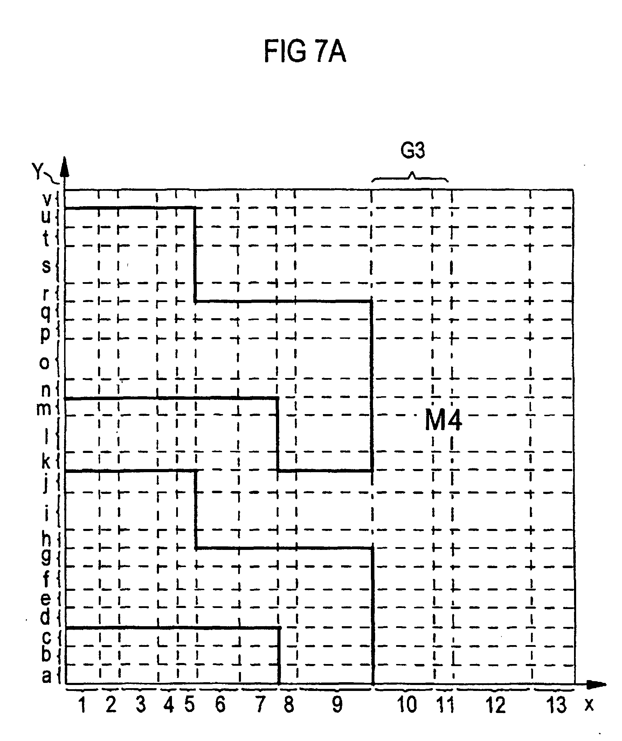

Mit Hilfe einer vierten Maske M4 aus Fotolack (s. Fig 7a), werden durch Implantation innerhalb der ersten Wannen Wa1 hakenförmige n-dotierte ca. 150nm tiefe Gebiete erzeugt. Die Dotierstoffkonzentration der hakenförmigen Gebiete beträgt ca. 5*10²⁰cm⁻³. Teile der hakenförmigen Gebiete sind als zweite Source/Drain-Gebiete 1 S/D2 von ersten Transistoren, als zweite Source/Drain-Gebiete 2 S/D2 von zweiten Transistoren, als zweite Source/Drain-Gebiete 5 S/D2 von fünften Transistoren und als zweite Source/Drain-Gebiete 6 S/D2 von sechsten Transistoren geeignet (s. Fig 2).

Dazu deckt die vierte Maske M4 in Speicherzellen jeweils Bereiche, in denen sich der vierzehnte horizontale Bereich n bis einschließlich der einundzwanzigste horizontale Bereich u mit dem ersten vertikalen Bereich 1 bis einschließlich dem fünften vertikalen Bereich 5 überschneiden, und Bereiche, in denen sich der vierte horizontale Bereich d bis einschließlich der zehnte horizontale Bereich j mit dem ersten vertikalen Bereich 1 bis einschließlich dem fünften vertikalen Bereich 5 überschneiden, und Bereiche, in denen sich der vierzehnte horizontale Bereich n bis einschließlich der siebzehnte horizontale Bereich q mit dem sechsten vertikalen Bereich 6 und dem siebten vertikalen Bereich 7 überschneiden, und Bereiche, in denen sich der vierte horizontale Bereich d bis einschließlich der siebte horizontale Bereich g mit dem sechsten vertikalen Bereich 6 und dem siebten vertikalen Bereich 7 überschneiden, und Bereiche, in denen sich der elfte horizontale Bereich k bis einschließlich der siebzehnte horizontale Bereich q mit dem achten vertikalen Bereich 8 und dem neunten vertikalen Bereich 9 überschneiden, und Bereiche, in denen sich der erste horizontale Bereich a bis einschließlich der siebte horizontale Bereich g mit dem achten vertikalen Bereich 8 und dem neunten vertikalen Bereich 9 überschneiden, nicht ab.

Mit Hilfe einer fünften Maske (nicht dargestellt) aus Fotolack werden innerhalb der zweiten Wannen Wa2 rechteckige ca. 150nm tiefe p-dotierte Gebiete erzeugt. Die Dotierstoffkonzentration der rechteckigen Gebiete beträgt ca. 5*10²⁰cm⁻³. Die p-dotierten Gebiete sind als erstes Source/Drain-Gebiete 3 S/D1 von dritten Transistoren und erste Source/Drain-Gebiete 4 S/D1 von vierten Transistoren geeignet (s. Fig 2).

Dazu deckt die fünfte Maske Bereiche, in denen sich der vierzehnte horizontale Bereich n bis einschließlich der zwanzigste horizontale Bereich t mit dem elften vertikalen Bereich 11 bis einschließlich dem dreizehnten vertikalen Bereich 13 überschneiden, und Bereiche, in denen sich der dritte horizontale Bereich c bis einschließlich der zehnte horizontale Bereich j mit dem elften vertikalen Bereich 11 bis einschließlich dem dreizehnten vertikalen Bereich 13 überschneiden, nicht ab.

Anschließend wird eine erste isolierende Schicht (nicht dargestellt) erzeugt, indem SiO₂ in einer Dicke von ca. 100nm abgeschieden wird. Über die erste isolierende Schicht wird durch Abscheiden von dotiertem Polysilizium eine ca. 100nm dicke leitende Schicht S1 erzeugt. Über die leitende Schicht S1 wird eine zweite isolierende Schicht (nicht dargestellt) erzeugt, indem SiO₂ in einer Dicke von ca. 100nm abgeschieden wird (s. Fig 3).

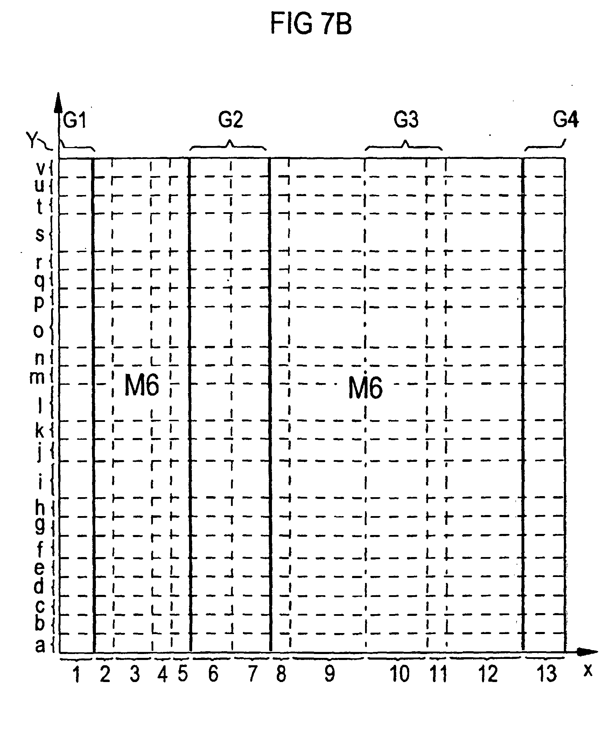

Mit Hilfe einer streifenförmigen sechsten Maske M6 aus Fotolack (s. Fig 7b) werden parallel zu den dritten Gräben G3 durch Ätzen von Silizium und SiO₂ ca. 500nm tiefe erste Gräben G1, zweite Gräben G2 und vierte Gräben G4 erzeugt (s. Fig 3). Die Tiefe der ersten Gräben G1, der zweiten Gräben G2 und der vierten Gräben G4 ab der Oberfläche O beträgt ca. 500 nm. Die ersten Gräben G1 und die zweiten Gräben G2 verlaufen innerhalb der ersten Wannen Wa1. Die vierten Gräben G4 verlaufen innerhalb der zweiten Wannen Wa2. Aus der ersten isolierenden Schicht entsteht dabei eine zweite isolierende Struktur I2, und aus der zweiten isolierenden Schicht entsteht eine vorläufige Struktur VS.

Dazu deckt die sechste Maske M6 in den Speicherzellen jeweils den ersten vertikalen Bereich 1, den sechsten vertikalen Bereich 6, den siebten vertikalen Bereich 7 und den dreizehnten vertikalen Bereich 13 nicht ab.

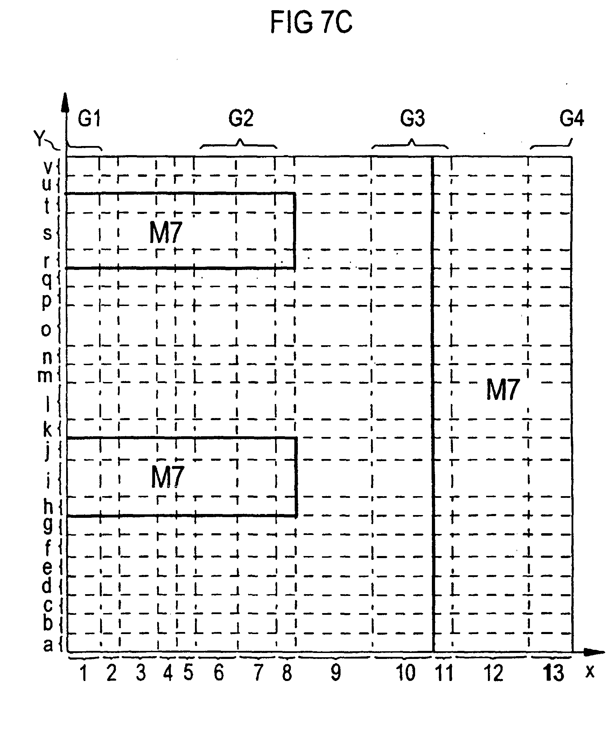

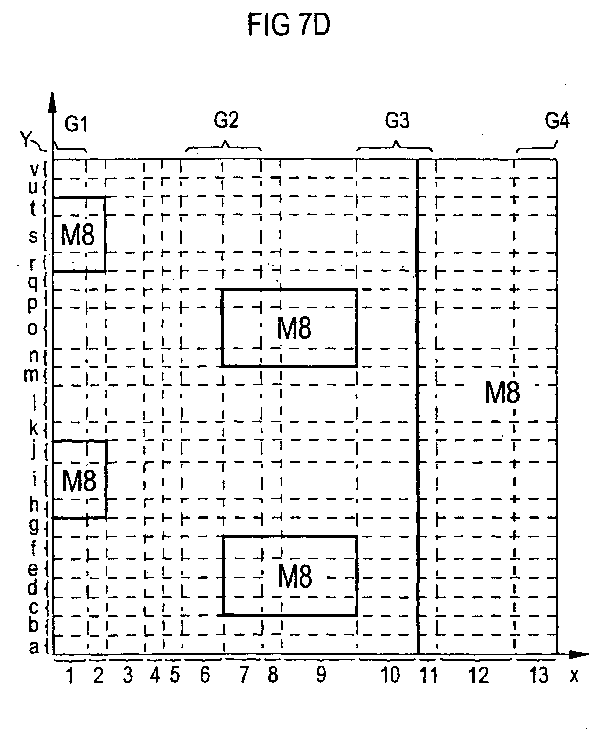

Mit Hilfe einer siebten Maske M7 aus Fotolack (s. Fig 7c) und einer achten Maske M8 aus Fotolack (s. Fig 7d) werden durch schräge Implantation an zweiten Flanken 1F2 der ersten Gräben G1 an ersten Flanken 2F1 der zweiten Gräben G2 und an zweiten Flanken 2F2 der zweiten Gräben G2 p-dotierte erste Channel-Stop-Gebiete C1 erzeugt (s. Fig 3).

Dazu deckt die siebte Maske M7 in den Speicherzellen jeweils die zweite Wanne Wa2, sowie Bereiche, in denen sich der achtzehnte horizontale Bereich r bis einschließlich der zwanzigste horizontale Bereich t mit dem ersten vertikalen Bereich 1 bis einschließlich dem achten vertikalen Bereichen 8 überschneiden, und Bereiche, in denen sich der achte horizontale Bereich h bis einschließlich der zehnte horizontale Bereich j mit dem ersten vertikalen Bereich 1 bis einschließlich dem achten vertikalen Bereich 8 überschneiden, ab. Die achte Maske M8 deckt in der Speicherzelle jeweils die zweite Wanne Wa2 sowie Bereiche, in denen sich der achte horizontale Bereich h bis einschließlich der zehnte horizontale Bereich j mit dem ersten vertikalen Bereich 1 und dem zweiten vertikalen Bereich 2 überschneiden, und Bereiche, in denen sich der achtzehnte horizontale Bereich r bis einschließlich der zwanzigste horizontale Bereich t mit dem ersten vertikalen Bereich 1 und dem zweiten vertikalen Bereich 2 überschneiden, und Bereiche, in denen sich der vierzehnte horizontale Bereich n bis einschließlich der sechzehnte horizontale Bereich p mit dem siebten vertikalen Bereich 7 bis einschließlich dem neunten vertikalen Bereich 9 überschneiden, und Bereiche, in denen sich der dritte horizontale Bereich c bis einschließlich der sechste horizontale Bereich f mit dem siebten vertikalen Bereich 7 bis einschließlich dem neunten vertikalen Bereich 9 überschneiden, ab.

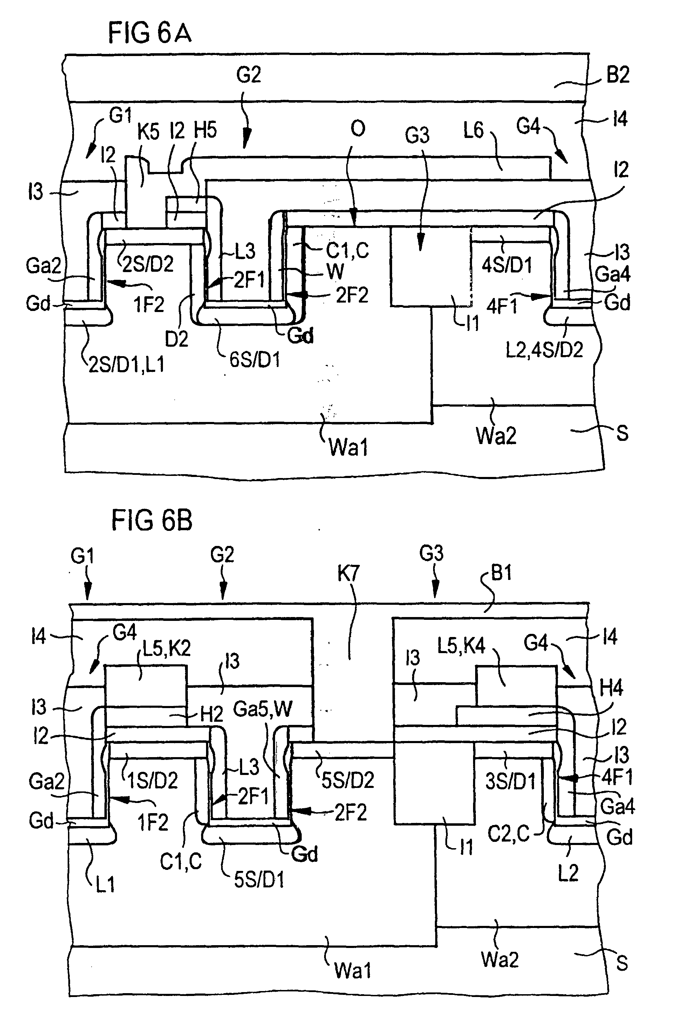

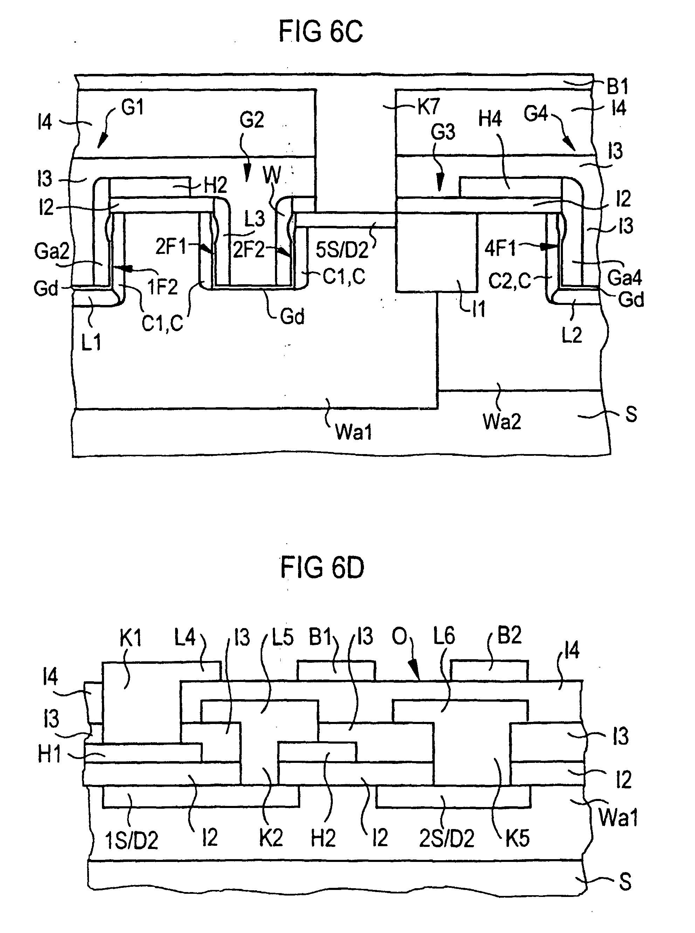

Mit Hilfe einer neunten Maske (nicht dargestellt) aus Fotolack werden durch schräge Implantation an ersten Flanken 4F1 der vierten Gräben G4 n-dotierte zweite Channel-Stop-Gebiete C2 erzeugt (in dem in Fig 3 dargestellten Querschnitt nicht sichtbar, s. Fig 6b).

Dazu deckt die neunte Maske in den Speicherzellen jeweils die erste Wannen Wa1 sowie Bereiche, in denen sich der achtzehnte horizontale Bereich r bis einschließlich der zwanzigste horizontale Bereich t mit dem zwölften vertikalen Bereich 12 und dem dreizehnten vertikalen Bereich 13 überschneiden, sowie Bereiche, in denen sich der achte horizontale Bereich h bis einschließlich der zehnte horizontale Bereich j mit dem zwölften vertikalen Bereich 12 und dem dreizehnten vertikalen Bereich 13 überschneiden, ab.

Die ersten Channel-Stop-Gebiete C1 und die zweiten Channel-Stop-Gebiete C2 bilden gemeinsam Channel-Stop-Gebiete C. Die Dotierstoffkonzentration der Channel-Stop-Gebiete C beträgt ca. 10¹⁹cm⁻³ und ist größer als die Dotierstoffkonzentration der ersten Wannen Wa1 und der zweiten Wannen Wa2. Durch ihre höhe Dotierstoffkonzentration verhindern die Channel-Stop-Gebiete C einen Stromfluß zwischen benachbarten Source/Drain-Gebieten.

Mit Hilfe einer zehnten Maske (nicht dargestellt) aus Fotolack werden durch schräge Implantation an den ersten Flanken 2 F1 der zweiten Gräben G2 n-dotierte Diffusionsgebiete erzeugt.

Dazu deckt die zehnte Maske in den Speicherzellen jeweils Bereiche, in denen sich der siebzehnte horizontale Bereich q bis einschließlich der einundzwanzigste horizontale Bereich u mit dem vierten vertikalen Bereich 4 bis einschließlich dem achten vertikalen Bereich 8 überschneiden, und Bereiche, in denen sich der siebte horizontale Bereich g bis einschließlich der elfte horizontale Bereich k mit dem vierten vertikalen Bereich 4 bis einschließlich dem achten vertikalen Bereich 8 überschneiden, nicht ab. Die Diffusionsgebiete teilen sich in erste Diffusionsgebiete und in zweite Diffusionsgebiete D2 auf (s. Fig 3). Die ersten Diffusionsgebiete grenzen an die zweiten Source/Drain-Gebiete 1 S/D2 der ersten Transistoren an, und die zweiten Diffusionsgebiete D2 grenzen an die zweiten Source/Drain-Gebiete 2 S/D2 der zweiten Transistoren an. Die Dotierstoffkonzentration der Diffusionsgebiete ist hoch und beträgt ca. 10²⁰cm⁻³.

Anschließend wird SiO₂ in einer Dicke von ca. 80nm in einem TEOS-Verfahren abgeschieden und rückgeätzt, um an den ersten Flanken der ersten Gräben G1, an den zweiten Flanken 1F2 der ersten Gräben G1, an den ersten Flanken 2F1 der zweiten Gräben G2, an den zweiten Flanken 2F2 der zweiten Gräben G2, an den ersten Flanken 4F1 der vierten Gräben G4 und an den zweiten Flanken der vierten Gräben G4 Spacer Sp zu erzeugen.

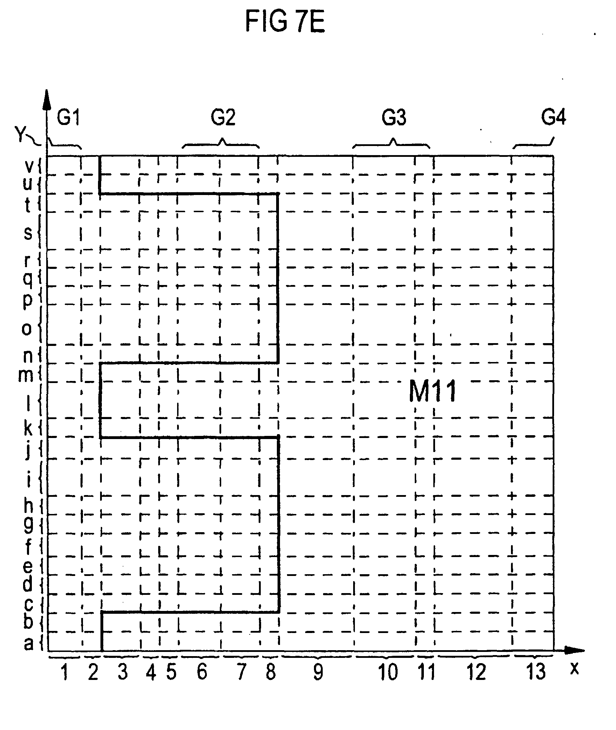

Mit Hilfe einer elften Maske M11 aus Fotolack (s. Fig 7e) werden durch Implantation an Böden der zweiten Gräben G2 mit jeweils einer Dotierstoffkonzentration von ca. 5*10²⁰cm⁻³ n-dotierte erste Source/Drain-Gebiete 5 S/D1 der fünften Transistoren (in dem in Fig 3 dargestellten Querschnitt nicht sichtbar, s. Fig 6b) und erste Source/Drain-Gebiete 6 S/D1 der sechsten Transistoren sowie an Böden der ersten Gräben G1 n-dotierte erste leitende Strukturen L1 erzeugt (s. Fig 3). Die ersten leitenden Strukturen L1 verlaufen entlang der Böden der ersten Gräben G1 und werden mit einem ersten Spannungsanschluß verbunden. Teile der ersten leitenden Strukturen L1 sind als erste Source/Drain-Gebiete der ersten Transistoren und als erste Source/Drain-Gebiete 2 S/D1 der zweiten Transistoren geeignet (s. Fig 3).

Dazu deckt die elfte Maske M11 in den Speicherzellen jeweils den ersten Graben G1 sowie Bereiche, in denen sich der vierzehnte horizontale Bereich n bis einschließlich der zwanzigste horizontale Bereich t mit dem dritten vertikalen Bereich 3 bis einschließlich dem achten vertikalen Bereichen 8 überschneiden, und rechteckige Bereiche, in denen sich der dritte horizontale Bereich c bis einschließlich der zehnte horizontale Bereich j mit dem dritten vertikalen Bereich 3 bis einschließlich dem achten vertikalen Bereich 8 überschneiden, nicht ab. Dadurch sind die ersten Source/Drain-Gebiete 5 S/D1 der fünften Transistoren von den ersten Source/Drain-Gebieten 6 S/D1 der sechsten Transistoren isoliert.

Mit Hilfe einer zwölften Maske (nicht dargestellt) aus Fotolack, die in den Speicherzellen jeweils den vierten Graben G4 nicht bedeckt, werden durch Implantation an den Böden der vierten Gräben G4 p-dotierte zweite leitende Strukturen L2 erzeugt (s. Fig 3). Die Dotierstoffkonzentration der zweiten leitenden Strukturen L2 beträgt ca. 5*10²⁰cm⁻³. Die zweiten leitenden Strukturen L2 werden mit einem zweiten Spannungsanschluß verbunden. Teile der zweiten leitenden Struktur L2 sind als zweite Source/Drain-Gebiete der dritten Transistoren und als zweite Source/Drain-Gebiete 4 S/D2 der vierten Transistoren geeignet.

Bei der Erzeugung der ersten Source/Drain-Gebiete 5 S/D1 der fünften Transistoren, der ersten Source/Drain-Gebiete 6 S/D1 der sechsten Transistoren, der ersten leitenden Strukturen L1 und der zweiten leitenden Strukturen L2 verhindern die vorläufige Struktur VS und die Spacer Sp die Implantation anderer Teile der Speicherzellen.

Mit z.B. HF als Ätzmittel wird SiO₂ geätzt, wodurch die vorläufige Struktur VS entfernt wird.

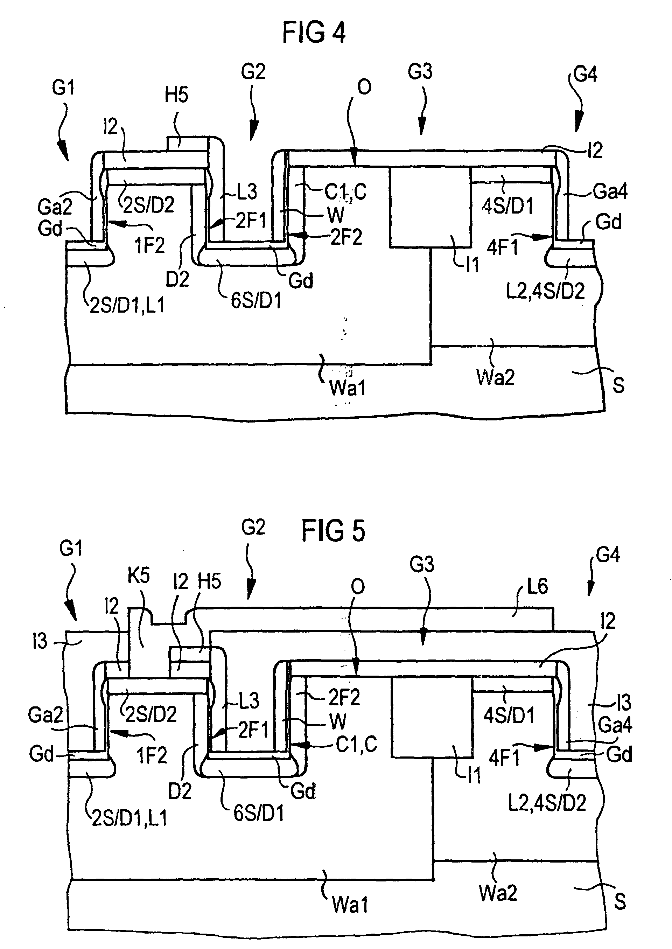

Anschließend wird durch thermische Oxidation ein Gatedielektrikum Gd erzeugt (s. Fig 4). Um Teile des Gatedielektrikums Gd an Flanken der durch die Erzeugung der ersten Gräben G1, der zweiten Gräben G2 und der vierten Gräben G4 strukturierten leitenden Schicht S1 zu entfernen, wird dotiertes Polysilizium in einer Dicke von ca. 40 nm abgeschieden und so weit zurückgeätzt, daß das Polysilizium in Form von Spacern unterhalb der Flanken der strukturierten leitenden Schicht S1 angeordnet ist. Anschließend wird mit z.B. HF SiO₂ geätzt so, daß, die Flanken der strukturierten leitenden Schicht S1 freigelegt werden.

In einer Dicke von ca. 80 nm wird dotiertes Polysilizium abgeschieden und rückgeätzt, wodurch an den Flanken der ersten Gräben G1, der zweiten Gräben G2 und der vierten Gräben G4 Spacer entstehen, die die strukturierte leitende Schicht S1 kontaktieren.

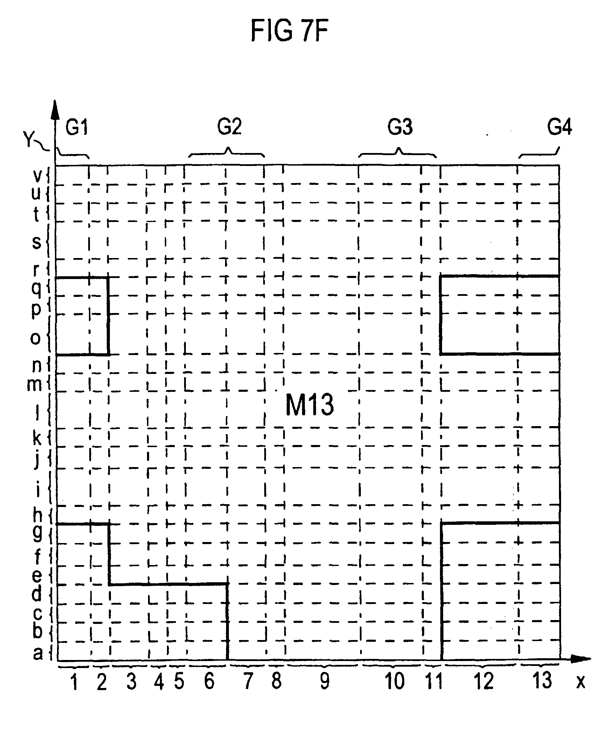

Mit Hilfe einer dreizehnten Maske M13 aus Fotolack (s. Fig 7f) wird Silizium geätzt, so, daß Teile der Spacer entfernt werden. Als Ätzmittel ist z.B. C₂F₆+O₂ geeignet. Dadurch entstehen erste Gateelektroden der ersten Transistoren, zweite Gateelektroden Ga2 der zweiten Transistoren, dritte Gateelektroden der dritten Transistoren, vierte Gateelektroden Ga4 der vierten Transistoren und dritte leitende Strukturen L3, die an den ersten Flanken 2F1 der zweiten Gräben G2 angeordnet sind (s. Fig 4). Spacer, die an den zweiten Flanken 2F2 der zweiten Gräben G2 angeordnet sind, werden nicht geätzt und sind als Wortleitungen W geeignet. Teile der Wortleitungen W sind als fünfte Gateelektroden Ga5 der fünften Transistoren und als sechste Gateeelektroden der sechsten Transistoren geeignet.

Dazu deckt die dreizehnte Maske M13 in den Speicherzellen jeweils Bereiche, in denen sich der fünfzehnte horizontale Bereich o bis einschließlich der siebzehnte horizontale Bereich q mit dem ersten vertikalen Bereich 1 und dem zweiten vertikalen Bereich 2 überschneiden, und Bereiche, in denen sich der fünfzehnte horizontale Bereich o bis einschließlich der siebzehnte horizontale Bereich q mit dem zwölften vertikalen Bereich 12 und dem dreizehnten vertikalen Bereich 13 überschneiden, und Bereiche, in denen sich der erste horizontale Bereich a bis einschließlich der siebte horizontale Bereich g mit dem ersten vertikalen Bereich 1 und dem zweiten vertikalen Bereich 2 überschneiden, und Bereiche, in denen sich der erste horizontale Bereich a bis einschließlich der vierte horizontale Bereich d mit dem dritten vertikalen Bereich 3 bis einschließlich dem sechsten vertikalen Bereich 6 überschneiden, und Bereiche, in denen sich der erste horizontale Bereich a bis einschließlich der siebte horizontale Bereich g mit dem zwölften vertikalen Bereich 12 und dem dreizehnten vertikalen Bereich 13 überschneiden, nicht ab.

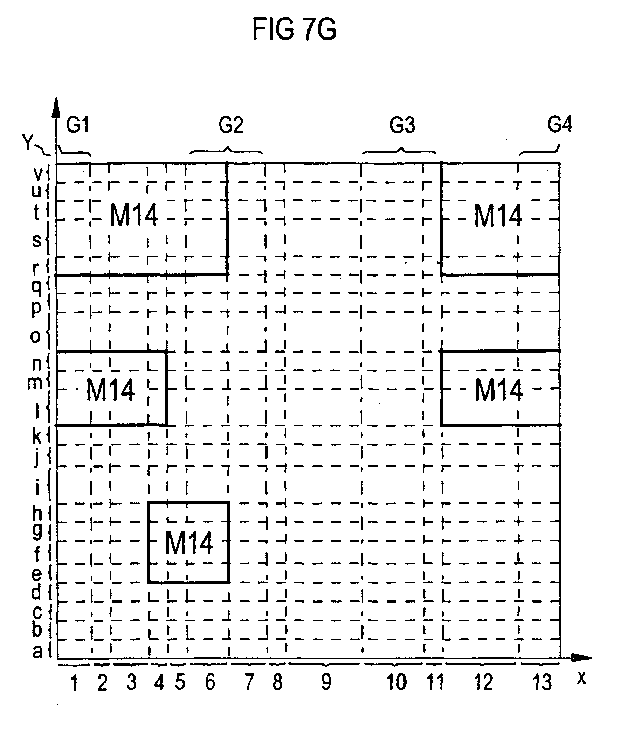

Mit Hilfe einer vierzehnten Maske M14 aus Fotolack (s. Fig 7g) entstehen durch Ätzen von Silizium aus der strukturierten leitenden Schicht S1 erste horizontale leitende Strukturen H1, zweite horizontale leitende Strukturen H2, dritte horizontale leitende Strukturen, vierte horizontale leitende Strukturen H4 und fünfte horizontale leitende Strukturen H5 (s. Fig 4, 6b, 6d). Als Ätzmittel ist z.B. C₂F₆+O₂ geeignet.

Dazu deckt die vierzehnte Maske M14 Bereiche in denen sich der achtzehnte horizontale Bereich r bis einschließlich der zweiundzwanzigste horizontale Bereich v mit dem ersten vertikalen Bereichen 1 bis einschließlich dem sechsten vertikalen Bereich 6 überschneiden, und Bereiche, in denen sich der zwölfte horizontale Bereich 1 bis einschließlich der vierzehnte horizontale Bereich n mit dem ersten vertikalen Bereich 1 bis einschließlich dem vierten vertikalen Bereich 4 überschneiden, und Bereiche, in denen sich der achtzehnte horizontale Bereiche r bis einschließlich der zweiundzwanzigste horizontale Bereich v mit dem elften vertikalen Bereich 11 bis einschließlich dem dreizehnten vertikalen Bereich 13 überschneiden, und Bereiche, in denen sich der zwölfte horizontale Bereich 1 bis einschließlich der vierzehnte horizontale Bereich n mit dem elften vertikalen Bereich 11 bis einschließlich dem dreizehnten vertikalen Bereich 13 überschneiden, und Bereiche, in denen sich der fünfte horizontale Bereich e bis einschließlich der achte horizontale Bereich h mit dem vierten vertikalen Bereich 4 bis einschließlich dem sechsten vertikalen Bereich 6 überschneiden, ab. Die ersten horizontalen leitenden Strukturen H1 grenzen an die ersten Gateelekktroden Ga1 der ersten Transistoren und an die dritten leitenden Strukturen L3 an. Die zweiten horizontalen leitenden Strukturen H2 grenzen an die zweiten Gateelektroden Ga2 der zweiten Transistoren an. Die dritten horizontalen leitenden Strukturen grenzen an die dritten Gateelektroden Ga3 der dritten Transistoren an. Die vierten horizontalen leitenden Strukturen H4 grenzen an die vierten Gateelektroden Ga4 der vierten Transistoren an. Die fünften horizontalen leitenden Strukturen H5 grenzen an die dritten leitenden Strukturen L3 an.

Anschließend wird in einem TEOS-Verfahren *SiO*₂ in einer Dicke von ca. 600 nm abgeschieden. Durch chemisch-mechanisches Polieren wird 500 nm *SiO*₂ abgetragen und planarisiert, wodurch eine dritte isolierende Struktur I3 entsteht (s. Fig 5).

Zur Erzeugung von zweiten Kontakten K2, die die zweiten Source/Drain-Gebiete 1 S/D2 der ersten Transistoren kontaktieren, von vierten Kontakten, die die ersten Source/Drain-Gebiete 3 S/D1 der dritten Transistoren kontaktieren, von fünften Kontakten K5, die die zweiten Source/Drain-Gebiete 2 S/D2 der zweiten Transistoren kontaktieren und von sechsten Kontakten, die die ersten Source/Drain-Gebiete 4 S/D1 der vierten Transistoren kontaktieren, wird mit Hilfe einer fünfzehnten Maske (nicht dargestellt) aus Fotolack *SiO*₂ selektiv zu Silizium geätzt, bis Teile der Source/Drain-Gebiete freigelegt werden. Als Ätzmittel ist z.B. CHF₃+O₂ geeignet.

Dazu deckt die fünfzehnte Maske in den Speicherzellen jeweils Bereiche, in denen sich der dreizehnte horizontale Bereich m bis einschließlich der fünfzehnte horizontale Bereich o mit dem zweiten vertikalen Bereich 2 bis einschließlich dem vierten vertikalen Bereich 4 überschneiden, und Bereiche, in denen sich der fünfte horizontale Bereich e bis einschließlich der achte horizontale Bereich h mit dem dritten vertikalen Bereich 3 bis einschließlich dem fünften vertikalen Bereich 5 überschneiden, und Bereiche, in denen sich der dreizehnte horizontale Bereich m bis einschließlich der fünfzehnte horizontale Bereich o mit dem zwölften vertikalen Bereich 12 überschneiden, und Bereiche, in denen sich der dritte horizontale Bereich c bis einschließlich der sechste horizontale Bereich f mit dem zwölften vertikalen Bereich 12 überschneiden, nicht ab.

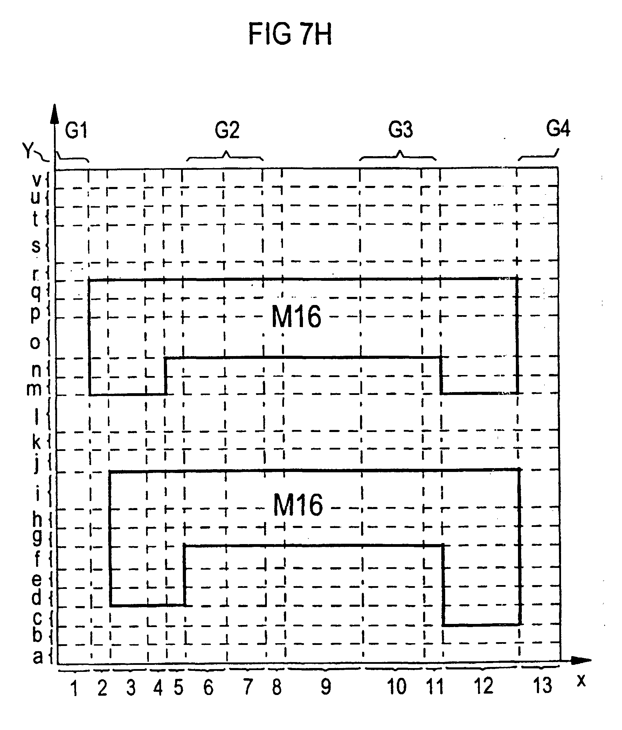

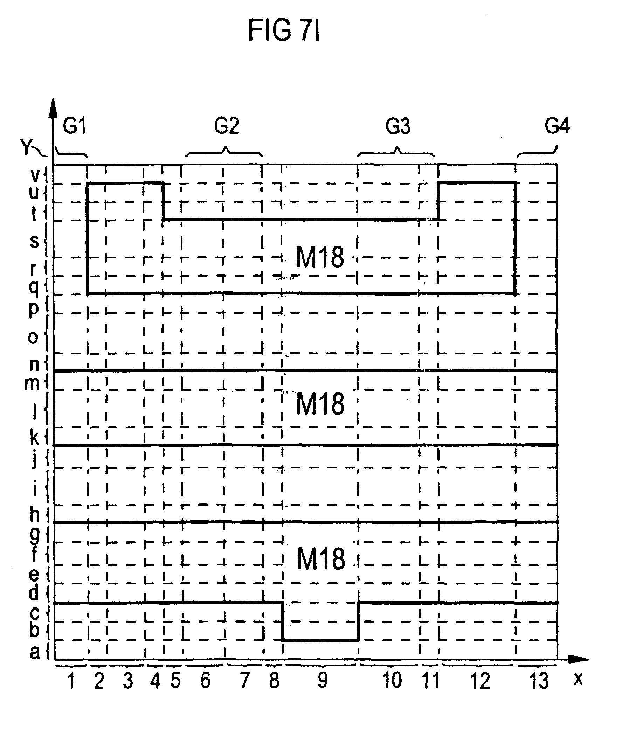

Anschließend wird in einer Dicke von ca. 200 nm Wolfram abgeschieden, wodurch die zweiten Kontakte K2, die vierten Kontakte K4, die fünften Kontakte K5 und die sechsten Kontakte entstehen (s. Fig 5, 6b). Mit Hilfe einer sechzehnten Maske M16 aus Fotolack (s. Fig 7h) wird Wolfram geätzt, wodurch fünfte leitende Strukturen L5 und sechste leitende Strukturen L6 entstehen (s. Fig 5, 6b). Als Ätzmittel ist z.B. SF₆ geeignet. Die fünften leitenden Strukturen L5 grenzen jeweils an einen zweiten Kontakt K2 und an einen vierten Kontakt K4 an. Die sechsten leitenden Strukturen L6 grenzen jeweils an einen fünften Kontakt K5 und an einen sechsten Kontakt an.

Dazu deckt die sechzehnte Maske M16 in den Speicherzellen jeweils einen ersten U-förmigen Bereich und einen zweiten U-förmigen Bereich ab. Der erste U-förmige Bereich besteht aus Bereichen, in denen sich der dreizehnte horizontale Bereich m bis einschließlich der siebzehnte horizontale Bereich q mit dem zweiten vertikalen Bereich 2 bis einschließlich dem vierten vertikalen Bereich 4 überschneiden, und Bereichen, in denen sich der fünfzehnte horizontale Bereich o bis einschließlich der siebzehnte horizontale Bereich q mit dem fünften vertikalen Bereich 5 bis einschließlich dem elften vertikalen Bereich 11 überschneiden, und Bereichen, in denen sich der dreizehnte horizontale Bereich m bis einschließlich der siebzehnte horizontale Bereich q mit dem zwölften vertikalen Bereich 12 überschneiden. Der zweite U-förmige Bereich besteht aus Bereichen, in denen sich der vierte horizontale Bereich d bis einschließlich der neunte horizontale Bereich i mit dem dritten vertikalen Bereich 3 bis einschließlich dem fünften vertikalen Bereich 5 überschneiden, und Bereichen, in denen sich der siebte horizontale Bereich g bis einschließlich der neunte horizontale Bereich i mit dem sechsten vertikalen Bereich 6 bis einschließlich dem elften vertikalen Bereich 11 überschneiden, und Bereichen, in denen sich der dritte horizontale Bereich c bis einschließlich der neunte horizontale Bereich i mit dem zwölften vertikalen Bereich 12 überschneiden.

Borphosphorglas wird in einer Dicke von ca. 600 nm abgeschieden. Mit Hilfe von chemisch-mechanischen Polierern wird das Borphosphorglas planarisiert, wodurch eine vierte isolierende Struktur I4 entsteht (s. Fig 6a). Zur Erzeugung von ersten Kontakten K1, die die zweiten Source/Drain-Gebiete 1 S/D2 der ersten Transistoren kontaktieren, von dritten Kontakten, die die ersten Source/Drain-Gebiete 3 S/D1 der dritten Transistoren kontaktieren, von siebten Kontakten K7, die die zweiten Source/Drain-Gebiete 5 S/D2 der fünften Transistoren kontaktieren, und von achten Kontakten, die die zweiten Source/Drain-Gebiete 6 S/D2 der sechsten Transistoren kontaktieren, wird mit Hilfe einer siebzehnten Maske (nicht dargestellt) aus Fotolack Borphosphorglas selektiv zu Silizium geätzt, bis Teile der Source/Drain-Gebiete freigelegt werden. Als Ätzmittel ist z.B. C₂F₆+O₂ geeignet.

Dazu deckt die siebzehnte Maske in den Speicherzellen jeweils Bereiche, in denen sich der neunzehnte horizontale Bereich s bis einschließlich der einundzwanzigste horizontale Bereich u mit dem zweiten vertikalen Bereich 2 bis einschließlich dem vierten vertikalen Bereich 4 überschneiden, und Bereiche, in denen sich der neunzehnte horizontale Bereich s bis einschließlich der einundzwanzigste horizontale Bereich u mit dem zwölften vertikalen Bereich 12 überschneiden, und Bereiche, in denen sich der elfte horizontale Bereich k bis einschließlich der dreizehnte horizontale Bereich m mit dem neunten vertikalen Bereich 9 überschneiden, und Bereiche, in denen der zweite horizontale Bereich b bis einschließlich der fünfte horizontale Bereich e mit dem neunten vertikalen Bereich 9 überschneiden, nicht ab. Anschließend wird Wolfram in einer Dicke von ca. 300 nm abgeschieden und rückgeätzt, wodurch die ersten Kontakte K1, die dritten Kontakte, die siebten Kontakte K7 und die achten Kontakte entstehen (s. Fig 6b, 6d).

Anschließend wird in einer Dicke von ca. 500 nm AlSiCu abgeschieden und mit einer achtzehnten Maske M18 aus Fotolack (s. Fig 7i) durch einen Ätzschritt strukturiert. Als Ätzmittel ist z.B. BCl₃+Cl₂+N₂+CH₄ geeignet. Dadurch entstehen vierte leitende Strukturen L4, erste Bitleitungen B1 und zweite Bitleitungen B2 (s. Fig 6a, 6b, 6d). In einer Speicherzelle grenzt eine vierte leitende Struktur L4 an einen ersten Kontakt K1 und an einen dritten Kontakt an. Die ersten Bitleitungen B1 sind streifenförmig, verlaufen senkrecht zu den ersten Gräben G1 und grenzen an die siebten Kontakte K7 an. Die zweiten Bitleitungen B2 sind im wesentlichen streifenförmig, verlaufen parallel zu den ersten Bitleitungen B1 und grenzen an die achten Kontakte an.

Dazu deckt die achtzehnte Maske M18 in den Speicherzellen jeweils Bereiche, in denen sich der siebzehnte horizontale Bereich q bis einschließlich der einundzwanzigste horizontale Bereich u mit dem zweiten vertikalen Bereich 2 bis einschließlich dem vierten vertikalen Bereich 4 überschneiden, und Bereiche, in denen sich der siebzehnte horizontale Bereich q bis einschließlich der neunzehnte horizontale Bereich s mit dem fünften vertikalen Bereich 5 bis einschließlich dem elften vertikalen Bereich 11 überschneiden, und Bereiche, in denen sich der siebzehnte horizontale Bereich q bis einschließlich der einundzwanzigste horizontale Bereich u mit dem zwölften vertikalen Bereich 12 überschneiden, den elften horizontalen Bereich k, den zwölften horizontalen Bereich 1, den dreizehnten horizontalen Bereich m, den vierten horizontalen Bereich d, den fünften horizontalen Bereich e, den sechsten horizontalen Bereich f, den siebten horizontalen Bereich g und Bereiche, in denen sich der zweite horizontale Bereich b und der dritte horizontale Bereich c mit dem neunten vertikalen Bereich 9 überschneiden, ab.

Es sind viele Variationen des Ausführungsbeispiels denkbar, die ebenfalls im Rahmen der Erfindung liegen. Insbesondere können die Abmessungen der beschriebenen Schichten, Gebiete, Bereiche und Gräben an die jeweiligen Erfordernisse angepaßt werden. Dasselbe gilt auch für die vorgeschlagenen Dotierstoffkonzentrationen. Strukturen und Schichten aus SiO₂ können insbesondere durch thermische Oxidation oder durch ein Abscheidungsverfahren erzeugt werden. Polysilizium kann sowohl während als auch nach der Abscheidung dotiert werden. Statt dotiertem Polysilizium lassen sich auch z.B. Metallsilizide und/oder Metalle verwenden. Statt abgeschiedenes SiO₂ durch chemisch-mechanisches Polieren abzutragen, kann auch rückgeätzt werden. Dasselbe gilt für die Erzeugung der leitenden Struktur.

## Patentansprüche

1. SRAM-Zellenanordnung,
- mit Speicherzellen, die jeweils 6 Transistoren umfassen,
- bei der ein erstes Source/Drain-Gebiet (1 S/D1) eines ersten der Transistoren mit einem ersten Source/Drain-Gebiet (2 S/D1) eines zweiten der Transistoren und einem ersten Spannungsanschluß verbunden ist,
- bei der ein zweites Source/Drain-Gebiet (1 S/D2) des ersten Transistors mit einem ersten Source/Drain-Gebiet (3 S/D1) eines dritten der Transistoren, einem ersten Source/Drain-Gebiet (5 S/D1) eines fünften der Transistoren, einer Gateelektrode (Ga2) des zweiten Transistors und einer Gateelektrode (Ga4) eines vierten der Transistoren verbunden ist,
- bei der eine Gateelektrode (Ga1) des ersten Transistors mit einem zweiten Source/Drain-Gebiet (2 S/D2) des zweiten Transistors, einem ersten Source/Drain-Gebiet (4 S/D1) des vierten Transistors, einer Gateelektrode (Ga3) des dritten Transistors und einem ersten Source/Drain-Gebiet (6 S/D1) eines sechsten der Transistoren verbunden ist,
- bei der ein zweites Source/Drain-Gebiet (3 S/D2) des dritten Transistors mit einem zweiten Source/Drain-Gebiet (4 S/D2) des vierten Transistors und einem zweiten Spannungsanschluß verbunden ist,
- bei der ein zweites Source/Drain-Gebiet (5 S/D2) des fünften Transistors mit einer ersten Bitleitung (B1) verbunden ist,
- bei der eine Gateelektrode (Ga5) des fünften Transistors mit einer Gateelektrode (Ga6) des sechsten Transistors und mit einer Wortleitung (W) verbunden ist,
- bei der ein zweites Source/Drain-Gebiet (6 S/D2) des sechsten Transistors mit einer zweiten Bitleitung (B2) verbunden ist,
- bei der der dritte Transistor und der vierte Transistor komplementär zum ersten Transistor, zum zweiten Transistor, zum fünften Transistor und zum sechsten Transistor sind,
- bei der die sechs Transistoren als vertikale MOS-Transistoren ausgebildet sind,
- bei der der erste Transistor und der zweite Transistor an einer zweiten Flanke (1F2) eines ersten Grabens (G1), der in einem Substrat (S) verläuft, angeordnet sind,
- bei der der fünfte Transistor und der sechste Transistor an einer zweiten Flanke (2F2) eines zweiten Grabens (G2), der in dem Substrat (S) und parallel zum ersten Graben (G1) verläuft, angeordnet sind,
- bei der der dritte Transistor und der vierte Transistor an einer ersten Flanke (4F1) eines vierten Grabens (G4), der in dem Substrat (S) und parallel zum zweiten Graben (G2) verläuft, angeordnet sind,
- bei der die Wortleitung (W) entlang der zweiten Flanke (2F2) des zweiten Grabens (G2) verläuft,
- bei der eine erste leitende Struktur (L1) mit dem ersten Spannungsanschluß und eine zweite leitende Struktur (L2) mit dem zweiten Spannungsanschluß verbunden sind,
- bei der die erste leitende Struktur (L1) entlang des ersten Grabens (G1) und die zweite leitende Struktur (L2) entlang des vierten Grabens (G4) verlaufen,
- bei der die erste Bitleitung (B1) und die zweite Bitleitung (B2) quer zu der Wortleitung (W) und parallel zueinander verlaufen,
- bei der das erste Source/Drain-Gebiet (1 S/D1) des ersten Transistors und das erste Source/Drain-Gebiet (2 S/D1) des zweiten Transistors mit der ersten leitenden Struktur (L1) verbunden sind,
- bei der das zweite Source/Drain-Gebiet (3 S/D2) des dritten Transistors und das zweite Source/Drain-Gebiet (4 S/D2) des vierten Transistors mit der zweiten leitenden Struktur (L2) verbunden sind.

2. SRAM-Zellenanordnung nach Anspruch 1, bei der Gateelektroden oder leitende Strukturen an außerhalb des ersten Grabens (G1), des zweiten Grabens (G2) und des vierten Grabens (G4) oberhalb einer Oberfläche (O) des Substrats (S) angeordnete horizontale leitende Strukturen angrenzen, über die sie kontaktiert sind.

3. SRAM-Zellenanordnung nach Anspruch 2,
- bei der der erste Graben (G1) und der zweite Graben (G2) in einer von einem zweiten Leitfähigkeitstyp dotierten ersten Wanne (Wa1) des Substrats (S) angeordnet sind,
- bei der der vierte Graben (G4) in einer von einem ersten, zum zweiten Leitfähigkeitstyp entgegensetzten Leitfähigkeitstyp dotierten zweiten Wanne (Wa2) des Substrats (S) angeordnet ist,
- bei der die erste leitende Struktur (L1) innerhalb des Substrats (S) an einen Boden des ersten Grabens (G1) angrenzt und vom ersten Leitfähigkeitstyp dotiert ist, und die zweite leitende Struktur innerhalb des Substrats (S) an einen Boden des vierten Grabens (G4) angrenzt und vom zweiten Leitfähigkeitstyp dotiert ist,
- bei der das erste Source/Drain-Gebiet (1 S/D1) des ersten Transistors und das erste Source/Drain-Gebiet (2 S/D1) des zweiten Transistors Teile der ersten leitenden Struktur (L1) sind,
- bei der das zweite Source/Drain-Gebiet (3 S/D2) des dritten Transistors und das zweite Source/Drain-Gebiet (4 S/D2) des vierten Transistors Teile der zweiten leitenden Struktur (L2) sind,
- bei der zwischen horizontalen leitenden Strukturen (H1, H2, H4, H5) und der Oberfläche (O) Teile einer zweiten isolierenden Struktur (I2) angeordnet sind,
- bei der die Gateelektrode (Gal) des ersten Transistors, die Gateelektrode (Ga2) des zweiten Transistors, die Gateelektrode (Ga3) des dritten Transistors, die Gateelektrode (Ga4) des vierten Transistors, die Gateelektrode (Ga5) des fünften Transistors und die Gateelektrode (Ga6) des sechsten Transistors als Spacer ausgebildet sind,
- bei der die Gateelektrode (Ga1) des ersten Transistors an eine erste horizontale leitende Struktur (H1), die Gateelektrode (Ga2) des zweiten Transistors an eine zweite horizontale leitende Struktur (H2), die Gateelektrode (Ga3) des dritten Transistors an eine dritte horizontale leitende Struktur und die Gateelektrode (Ga4) des vierten Transistors an eine vierte horizontale leitende Struktur (H4) angrenzt,
- bei der die Wortleitung (W) als Spacer an der zweiten Flanke (2F2) des zweiten Grabens (G2) ausgebildet ist,
- bei der die Gateelektrode (Ga5) des fünften Transistors und die Gateelektrode (Ga6) des sechsten Transistors Teile der Wortleitung (W) sind,
- bei der eine dritte leitende Struktur (L3) als Spacer an der ersten Flanke (2F1) des zweiten Grabens (G2) ausgebildet ist,
- bei der die dritte leitende Struktur (L3) an die erste horizontale leitende Struktur (H1) und an die fünfte horizontale leitende Struktur (H5) angrenzt,
- bei der die zweite Flanke (1F2) des ersten Grabens (G1), die erste Flanke (2F1) des zweiten Grabens (G2), die zweite Flanke (2F2) des zweiten Grabens (G2) und die erste Flanke (4F1) des vierten Grabens (G4) mit einem Gatedielektrikum (Gd) versehen sind,
- bei der das zweite Source/Drain-Gebiet (1 S/D2) des ersten Transistors und das zweite Source/Drain-Gebiet (2 S/D2) des zweiten Transistors an die Oberfläche (O) sowie an die zweite Flanke (1F2) des ersten Grabens (G1) und an die erste Flanke (2F1) des zweiten Grabens (G2) angrenzen,
- bei der das erste Source/Drain-Gebiet (3 S/D1) des dritten Transistors und das erste Source/Drain-Gebiet (4 S/D1 des vierten Transistors an die Oberfläche (O) sowie an die erste Flanke (4 F1) des vierten Grabens (G4) angrenzen,
- bei der das zweite Source/Drain-Gebiet (5 S/D2) des fünften Transistors und das zweite Source/Drain-Gebiet (6 S/D2) des sechsten Transistors an die Oberfläche (O) sowie an die zweite Flanke (2F2) des zweiten Grabens (G2) angrenzen,
- bei der die erste horizontale leitende Struktur (H1) über einen ersten Kontakt (K1) mit einer vierten leitenden Struktur (L4) verbunden ist,
- bei der die dritte horizontale leitende Struktur über einen dritten Kontakt (K3) mit der vierten leitenden Struktur (L4) verbunden ist,
- bei der die vierte leitende Struktur (L4) oberhalb der zweiten horizontalen leitenden Strukturen (H1, H2, H4, H5) angeordnet ist,
- bei der das zweite Source/Drain-Gebiet (1 S/D2) des ersten Transistors über einen zweiten Kontakt (K2) mit der zweiten horizontalen leitenden Struktur (H2) und einer fünften leitenden Struktur (L5) verbunden ist,
- bei der die fünfte leitende Struktur (L5) oberhalb der horizontalen leitenden Strukturen (H1, H2, H4, H5) und unterhalb der vierten leitenden Struktur (L4) angeordnet ist,
- bei der das erste Source/Drain-Gebiet (3 S/D1) des dritten Transistors über einen vierten Kontakt (K4) mit der vierten horizontalen leitenden Struktur (H4) und der fünften leitenden Struktur (L5) verbunden ist,
- bei der das zweite Source/Drain-Gebiet (2 S/D2) des zweiten Transistors über einen fünften Kontakt (K5) mit der fünften horizontalen leitenden Struktur (H5) und einer sechsten leitenden Struktur (L6) verbunden ist,
- bei der die Höhe der sechsten leitenden Struktur (L6) bezüglich einer Achse senkrecht zur Oberfläche (O) der Höhe der fünften leitenden Struktur (L5) entspricht,
- bei der das erste Source/Drain-Gebiet (4 S/D1) des vierten Transistors über einen sechsten Kontakt (K6) mit der sechsten leitenden Struktur (L6) verbunden ist,
- bei der das zweite Source/Drain-Gebiet (5 S/D2) des fünften Transistors über einen siebten Kontakt (K7) mit der ersten Bitleitung (B1) und das zweite Source/Drain-Gebiet (6 S/D2) des sechsten Transistors über einen achten Kontakt (K8) mit der zweiten Bitleitung (B2) verbunden sind,
- bei der ein vom ersten Leitfähigkeitstyp dotierter erster Diffusionsbereich innerhalb des Substrats (S) an die erste Flanke (2F1) des zweiten Grabens (G2), an das zweite Source/Drain-Gebiet (1 S/D1) des ersten Transistors und an das erste Source/Drain-Gebiet (5 S/D1) des fünften Transistors angrenzt,
- bei der ein vom ersten Leitfähigkeitstyp dotierter zweiter Diffusionsbereich (D2) innerhalb des Substrats (S) an die erste Flanke (2F1) des zweiten Grabens (G2), an das zweite Source/Drain-Gebiet (2 S/D2) des zweiten Transistors und an das erste Source/Drain-Gebiet (6 S/D1) des sechsten Transistors angrenzt.

4. SRAM-Zellenanordnung nach den Ansprüchen 1, 2 und/oder 3,
- bei der innerhalb des Substrats (S) an Teilen der Flanken der Gräben an denen keine Gateelektroden und keine Diffusionsbereiche angrenzen, hochdotierte Channel-Stop-Gebiete (C) angeordnet sind,
- bei der eine streifenförmige erste Isolationsstruktur (I1) parallel zu und zwischen dem zweiten Graben (G2) und dem vierten Graben (G4) verläuft.

5. SRAM-Zellenanordnung nach einem der Ansprüche 1 bis 4, bei der entlang der ersten Bitleitung (B1) benachbarte Speicherzellen bezüglich einer Achse, die entlang einer Mittellinie eines ersten Grabens (G1) oder eines vierten Grabens (G4) verläuft, spiegelsymmetrisch zueinander angeordnet sind.

6. Verfahren zur Herstellung einer SRAM-Zellenanordnung,
- bei dem Speicherzellen, die jeweils einen ersten Transistor, einen zweiten Transistor, einen dritten Transistor, einen vierten Transistor, einen fünften Transistor und einen sechsten Transistor umfassen, erzeugt werden,
- bei dem Wortleitungen (W), erste Bitleitungen (B1) und zweite Bitleitungen (B2) erzeugt werden,
- bei dem Gateelektroden, erste Source/Drain-Gebiete und zweite Source/Drain-Gebiete erzeugt werden,
- bei dem ein erstes Source/Drain-Gebiete (1 S/D1) des ersten Transistors mit einem ersten Source/Drain-Gebiet (2 S/D1) des zweiten Transistors und einem ersten Spannungsanschluß verbunden wird,
- bei dem ein zweites Source/Drain-Gebiet (1 S/D2) des ersten Transistors mit einem ersten Source/Drain-Gebiet (3 S/D1) des dritten Transistors, einem ersten Source/Drain-Gebiet (5 S/D1) des fünften Transistors, einer Gateelektrode (Ga2) des zweiten Transistors und einer Gateelektrode (Ga4) des vierten Transistors verbunden wird,
- bei dem eine Gateelektrode (Ga1) des ersten Transistors mit einem zweiten Source/Drain-Gebiet (2 S/D2) des zweiten Transistors, einem ersten Source/Drain-Gebiet (4 S/D1) des vierten Transistors, einer Gateelektrode (Ga3) des dritten Transistors und einem ersten Source/Drain-Gebiet (6 S/D1) eines sechsten Transistors verbunden wird,
- bei dem ein zweites Source/Drain-Gebiet (3 S/D2) des dritten Transistors mit einem zweiten Source/Drain-Gebiet (4 S/D2) des vierten Transistors und einem zweiten Spannungsanschluß verbunden wird,
- bei dem ein zweites Source/Drain-Gebiet (5 S/D2) des fünften Transistors mit einer ersten Bitleitung (B1) verbunden wird,
- bei dem eine Gateelektrode (Ga5) des fünften Transistors mit einer Gateelektrode (Ga6) des sechsten Transistors und mit einer Wortleitung (W) verbunden wird,
- bei dem ein zweites Source/Drain-Gebiet (6 S/D2) des sechsten Transistors mit einer zweiten Bitleitung (B2) verbunden wird,
- bei dem der dritte Transistor und der vierte Transistor als zum ersten Transistor, zum zweiten Transistor, zum fünften Transistor und zum sechsten Transistor komplementäre Transistoren ausgebildet werden,
- bei dem die sechs Transistoren als vertikale MOS-Transistoren gebildet werden,
- bei dem in einem Substrat (S) erste Gräben (G1), zweite Gräben (G2) und vierte Gräben (G4), die im wesentlichen parallel zueinander verlaufen, erzeugt werden,
- bei dem Flanken der ersten Gräben (G1), der zweiten Gräben (G2) und der vierten Gräben (G4) mit einem Gatedielektrikum (Gd) versehen werden,
- bei dem der erste Transistor und der zweite Transistor an eine zweite Flanke (1F2) eines ersten Grabens (G1) angrenzend gebildet werden,
- bei dem der fünfte Transistor und der sechste Transistor an eine zweite Flanke (2F2) eines zweiten Grabens (G2) angrenzend gebildet werden,
- bei dem der dritte Transistor und der vierte Transistor an eine erste Flanke (4F1) eines viertes Grabens (G4) angrenzend gebildet werden,
- bei dem die Wortleitung (W) entlang der zweiten Flanke (2F2) des zweiten Grabens (G2) gebildet wird,
- bei dem entlang des ersten Grabens (G1) eine erste leitende Struktur (L1) gebildet wird, die mit dem ersten Spannungsanschluß verbunden wird,
- bei dem entlang des vierten Grabens (G4) eine zweite leitende Struktur (L2) erzeugt wird, die mit dem zweiten Spannungsanschluß verbunden wird,
- bei dem quer zu der Wortleitung (W) die erste Bitleitung (B1) und parallel zur ersten Bitleitung (B1) die zweite Bitleitung (B2) gebildet werden,
- bei dem das erste Source/Drain-Gebiet (1 S/D1) des ersten Transistors und das erste Source/Drain-Gebiet (2 S/D1) des zweiten Transistors mit der ersten leitenden Struktur (L1) verbunden werden,
- bei dem das zweite Source/Drain-Gebiet (3 S/D2) des dritten Transistors und das zweite Source/Drain-Gebiet (4 S/D2) des vierten Transistors mit der zweiten leitenden Struktur (L2) verbunden werden.

7. Verfahren nach Anspruch 6, bei der zur Kontaktierung von Gateelektroden oder leitenden Strukturen außerhalb des ersten Grabens (G1), des zweiten Grabens (G2) und des vierten Grabens (G4) oberhalb einer Oberfläche (O) des Substrats (S) horizontale leitende Strukturen erzeugt werden, so, daß die horizontalen leitenden Strukturen jeweils an eine Gateelektrode oder/und eine leitende Struktur angrenzen.

8. Verfahren nach Anspruch 7,
- bei dem an der Oberfläche (O) durch Implantation das zweite Source/Drain-Gebiet (1 S/D2) des ersten Transistors, das zweite Source/Drain-Gebiet (2 S/D2) des zweiten Transistors, das zweite Source/Drain-Gebiet (5 S/D2) des fünften Transistors, das zweite Source/Drain-Gebiet (6 S/D2) des sechsten Transistors, das erste Source/Drain-Gebiet (3 S/D1) des dritten Transistors und das erste Source/Drain-Gebiet (4 S/D1) des vierten Transistors erzeugt werden,
- bei dem anschließend die ersten Gräben (G1) die zweiten Gräben (G2) und die vierten Gräben (G4) erzeugt werden,
- bei dem das zweite Source/Drain-Gebiet (1 S/D2) des ersten Transistors, das zweite Source/Drain-Gebiet (2 S/D2) des zweiten Transistors, das zweite Source/Drain-Gebiet (5 S/D2) des fünften Transistors, das zweite Source/Drain-Gebiet (6 S/D2) des sechsten Transistors, das erste Source/Drain-Gebiet (3 S/D1) des dritten Transistors und das erste Source/Drain-Gebiet (4 S/D1) des vierten Transistors, die ersten Gräben (G1), die zweiten Gräben (G2) und die vierten Gräben (G4) so erzeugt werden, daß das zweite Source/Drain-Gebiet (1 S/D2) des ersten Transistors und das zweite Source/Drain-Gebiet (2 S/D2) des zweiten Transistors an die zweite Flanke (1F2) des ersten Grabens (G1) und an die erste Flanke (2F1) des zweiten Grabens (G2) angrenzen und so, daß das zweite Source/Drain-Gebiet (5 S/D2) des fünften Transistors und das zweite Source/Drain-Gebiet (6 S/D2) des sechsten Transistors an die zweite Flanke (2F2) des zweiten Grabens (G2) angrenzen, und so, daß das erste Source/Drain-Gebiet (3 S/D1) des dritten Transistors und das erste Source/Drain-Gebiet (4 S/D1) des vierten Transistors an die erste Flanke (4F1) des vierten Grabens (4) angrenzen,
- bei dem angrenzend an das zweite Source/Drain-Gebiet (1 S/D2) des ersten Transistors an der ersten Flanke (2F1) des zweiten Grabens (G2) innerhalb des Substrats (S) durch schräge Implantation ein erster Diffusionsbereich erzeugt wird,
- bei dem angrenzend an das zweite Source/Drain-Gebiet (2 S/D2) des zweiten Transistors an der ersten Flanke (2F1) des zweiten Grabens (G2) innerhalb des Substrats (S) durch schräge Implantation ein zweiter Diffusionsbereich (D2) erzeugt wird,
- bei dem durch Implantation innerhalb des Substrats (S) die von einem ersten Leitfähigkeitstyp dotierte erste leitende Struktur (L1) an einem Boden des ersten Grabens (G1) erzeugt wird,
- bei dem durch Implantation an einem Boden des zweiten Grabens (G2) das erste Source/Drain-Gebiet (5 S/D1) des fünften Transistors und das erste Source/Drain-Gebiet (6 S/D1) des sechsten Transistors erzeugt werden,
- bei dem durch Implantation an einem Boden des vierten Grabens (G4) von einem zweiten, zum ersten Leitfähigkeitstyp entgegengesetzten zweite Leitfähigkeitstyp dotierte zweite dotierte leitende Struktur (L2) erzeugt wird,
- bei dem durch Abscheiden, Rückätzen und maskiertes Ätzen von leitendem Material an der zweiten Flanke (2F2) des zweiten Grabens (G2) die Wortleitung (W), an der zweiten Flanke (1F2) des ersten Grabens (G1) die Gateelektrode (Ga1) des ersten Transistors und die Gateelektrode (Ga2) des zweiten Transistors, an der ersten Flanke (2F1) des zweiten Grabens (G2) eine dritte leitende Struktur (L3) und an der ersten Flanke (4F1) des vierten Grabens (G4) die Gateelektrode (Ga3) des dritten Transistors und die Gateelektrode (Ga4) des vierten Transistors erzeugt werden,
- bei dem durch Abscheiden von isolierendem Material auf die Oberfläche (O) eine zweite isolierende Struktur (I2) erzeugt wird,
- bei dem durch Abscheiden von leitendem Material auf die zweite isolierende Struktur (I2) eine leitende Schicht (S1) gebildet wird,
- bei dem durch Ätzen von leitenden Material mit Hilfe einer vierzehnten Maske (M14) eine erste horizontale leitende Struktur (H1), eine zweite horizontale leitende Struktur (H2), eine dritte horizontale leitende Struktur, eine vierte horizontale leitende Struktur (H4) und eine fünfte horizontale leitende Struktur (H5) erzeugt werden,
- bei dem durch Abscheiden und Rückätzen von isolierendem Material eine dritte isolierende Struktur (I3) erzeugt wird,
- bei dem ein zweiter Kontakt (K2), der an das zweite Source/Drain-Gebiet (1 S/D2) des ersten Transistors angrenzt, ein fünfter Kontakt (K5), der an das zweite Source/Drain-Gebiet (2 S/D2) des zweiten Transistors angrenzt, ein vierter Kontakt (K4), der an das erste Source/Drain-Gebiet (3 S/D1) des dritten Transistors angrenzt, ein sechster Kontakt (K6), der an das erste Source/Drain-Gebiet (4 S/D1) des vierten Transistors angrenzt, eine fünfte leitende Struktur (L5), die an den zweiten Kontakt (K2) und an den vierten Kontakt (K4) angrenzt und eine sechste leitende Struktur (L6), die an den fünften Kontakt (K5) und an den sechsten Kontakt (K6) angrenzt, erzeugt werden, indem mit Hilfe einer fünfzehnten Maske (M15) isolierendes Material geätzt und anschließend leitendes Material abgeschieden und mit Hilfe einer sechzehnten Maske (M16) strukturiert wird,
- bei dem durch Abscheiden und Rückätzen von isolierendem Material eine vierte isolierende Struktur (I4) erzeugt wird,
- bei dem ein erster Kontakt (K1), der an die erste horizontale leitende Struktur (H1) angrenzt, ein dritter Kontakt (K3), der an die dritte horizontale leitende Struktur angrenzt, ein siebter Kontakt (K7), der an das zweite Source/Drain-Gebiet (5 S/D2) des fünften Transistors angrenzt, ein achter Kontakt (K8), der an das zweite Source/Drain-Gebiet (6 S/D2) des sechsten Transistors angrenzt, eine vierte leitende Struktur (L4), die an den ersten Kontakt (K1) und an den dritten Kontakt (K3) angrenzt, eine erste Bitleitung (B1), die an den siebten Kontakt (K7) angrenzt und eine zweite Bitleitung (B2), die an den achten Kontakt (K8) angrenzt, erzeugt werden, indem mit Hilfe einer siebzehnten Maske (M17) isolierendes Material geätzt wird und anschließend leitendes Material abgeschieden und mit Hilfe einer achtzehnten Maske (M18) strukturiert wird.

9. Verfahren nach den Ansprüchen 6, 7 und/oder 8,
- bei dem parallel zueinander laufende dritte Gräben (G3) erzeugt und mit isolierendem Material gefüllt werden, wodurch erste isolierende Strukturen (I1) erzeugt werden,
- bei dem der zweite Graben (G2) und der vierte Graben (G4) so erzeugt werden, daß sie parallel zum dritten Graben (G3) verlaufen, und daß der dritte Graben (G3) zwischen ihnen liegt,
- bei dem durch schräge Implantation hochdotierte Channel-Stop Gebiete (C) an Teilen der Flanken der Gräben, an die keine Gateelektroden und keine Diffusionsbereiche angrenzen, erzeugt werden.

10. Verfahren nach einem der Ansprüche 6 bis 9, bei dem entlang der ersten Bitleitung (B1) benachbarte Speicherzellen spiegelsymmetrisch zueinander bezüglich einer Achse, die entlang einer Mittellinie eines ersten Grabens (G1) oder eines vierten Grabens (G4) verläuft, erzeugt werden.

## Claims

1. SRAM cell arrangement,
- having memory cells which each comprise 6 transistors,
- in which a first source/drain region (1 S/D1) of a first transistor of the said transistors is connected to a first source/drain region (2 S/D1) of a second transistor of the said transistors and to a first voltage terminal,
- in which a second source/drain region (1 S/D2) of the first transistor is connected to a first source/drain region (3 S/D1) of a third transistor of the said transistors, to a first source/drain region (5 S/D1) of a fifth transistor of the said transistors, to a gate electrode (Ga2) of the second transistor and to a gate electrode (Ga4) of a fourth transistor of the said transistors,
- in which a gate electrode (Ga1) of the first transistor is connected to a second source/drain region (2 S/D2) of the second transistor, to a first source/drain region (4 S/D1) of the fourth transistor, to a gate electrode (Ga3) of the third transistor and to a first source/drain region (6 S/D1) of a sixth transistor of the said transistors,
- in which a second source/drain region (3 S/D2) of the third transistor is connected to a second source/drain region (4 S/D2) of the fourth transistor and to a second voltage terminal,
- in which a second source/drain region (5 S/D2) of the fifth transistor is connected to a first bit line (B1),
- in which a gate electrode (Ga5) of the fifth transistor is connected to a gate electrode (Ga6) of the sixth transistor and to a word line (W),
- in which a second source/drain region (6 S/D2) of the sixth transistor is connected to a second bit line (B2),
- in which the third transistor and the fourth transistor are complementary to the first transistor, to the second transistor, to the fifth transistor and to the sixth transistor,
- in which the six transistors are designed as vertical MOS transistors,
- in which the first transistor and the second transistor are arranged on a second sidewall (1F2) of a first trench (G1), which runs in a substrate (S),
- in which the fifth transistor and the sixth transistor are arranged on a second sidewall (2F2) of a second trench (G2), which runs in the substrate (S) and parallel to the first trench (G1),
- in which the third transistor and the fourth transistor are arranged on a first sidewall (4F1) of a fourth trench (G4), which runs in the substrate (S) and parallel to the second trench (G2),
- in which the word line (W) runs along the second sidewall (2F2) of the second trench (G2),
- in which a first conductive structure (L1) is connected to the first voltage terminal and a second conductive structure (L2) is connected to the second voltage terminal,
- in which the first conductive structure (L1) runs along the first trench (G1) and the second conductive structure (L2) runs along the fourth trench (G4),
- in which the first bit line (B1) and the second bit line (B2) run transversely with respect to the word line (W) and parallel to one another,
- in which the first source/drain region (1 S/D1) of the first transistor and the first source/drain region (2 S/D1) of the second transistor are connected to the first conductive structure (L1),
- in which the second source/drain region (3 S/D2) of the third transistor and the second source/drain region (4 S/D2) of the fourth transistor are connected to the second conductive structure (L2).

2. SRAM cell arrangement according to Claim 1, in which gate electrodes or conductive structures adjoin horizontal conductive structures arranged outside the first trench (G1), the second trench (G2) and the fourth trench (G4) above a surface (O) of the substrate (S) and contact is made with them via the said horizontal conductive structures.

3. SRAM cell arrangement according to Claim 2,
- in which the first trench (G1) and the second trench (G2) are arranged in a first well (Wa1) in the substrate (S), which first well is doped by a second conductivity type,
- in which the fourth trench (G4) is arranged in a second well (Wa2) in the substrate (S), which second well is doped by a first conductivity type opposite to the second conductivity type,
- in which the first conductive structure (L1), within the substrate (S), adjoins a bottom of the first trench (G1) and is doped by the first conductivity type, and the second conductive structure, within the substrate (S), adjoins a bottom of the fourth trench (G4) and is doped by the second conductivity type,
- in which the first source/drain region (1 S/D1) of the first transistor and the first source/drain region (2 S/D1) of the second transistor are parts of the first conductive structure (L1),
- in which the second source/drain region (3 S/D2) of the third transistor and the second source/drain region (4 S/D2) of the fourth transistor are parts of the second conductive structure (L2),
- in which parts of a second insulating structure (I2) are arranged between horizontal conductive structures (H1, H2, H4, H5) and the surface (O),
- in which the gate electrode (Gal) of the first transistor, the gate electrode (Ga2) of the second transistor, the gate electrode (Ga3) of the third transistor, the gate electrode (Ga4) of the fourth transistor, the gate electrode (Ga5) of the fifth transistor and the gate electrode (Ga6) of the sixth transistor are designed as spacers,
- in which the gate electrode (Ga1) of the first transistor adjoins a first horizontal conductive structure (H1), the gate electrode (Ga2) of the second transistor adjoins a second horizontal conductive structure (H2), the gate electrode (Ga3) of the third transistor adjoins a third horizontal conductive structure and the gate electrode (Ga4) of the fourth transistor adjoins a fourth horizontal conductive structure (H4),
- in which the word line (W) is designed as a spacer on the second sidewall (2F2) of the second trench (G2),
- in which the gate electrode (Ga5) of the fifth transistor and the gate electrode (Ga6) of the sixth transistor are parts of the word line (W),
- in which a third conductive structure (L3) is designed as a spacer on the first sidewall (2F1) of the second trench (G2),
- in which the third conductive structure (L3) adjoins the first horizontal conductive structure (H1) and the fifth horizontal conductive structure (H5),
- in which the second sidewall (1F2) of the first trench (G1), the first sidewall (2F1) of the second trench (G2), the second sidewall (2F2) of the second trench (G2) and the first sidewall (4F1) of the fourth trench (G4) are provided with a gate dielectric (Gd),
- -in which the second source/drain region (1 S/D2) of the first transistor and the second source/drain region (2 S/D2) of the second transistor adjoin the surface (O) and also the second sidewall (1F2) of the first trench (G1) and the first sidewall (2F1) of the second trench (G2),
- in which the first source/drain region (3 S/D1) of the third transistor and the first source/drain region (4 S/D1) of the fourth transistor adjoin the surface (O) and also the first sidewall (4 F1) of the fourth trench (G4),
- in which the second source/drain region (5 S/D2) of the fifth transistor and the second source/drain region (6 S/D2) of the sixth transistor adjoin the surface (O) and also the second sidewall (2F2) of the second trench (G2),
- in which the first horizontal conductive structure (H1) is connected to a fourth conductive structure (L4) via a first contact (K1),
- in which the third horizontal conductive structure is connected to the fourth conductive structure (L4) via a third contact (K3),
- in which the fourth conductive structure (L4) is arranged above the second horizontal conductive structures (H1, H2, H4, H5),
- in which the second source/drain region (1 S/D2) of the first transistor is connected via a second contact (K2) to the second horizontal conductive structure (H2) and to a fifth conductive structure (L5),
- in which the fifth conductive structure (L5) is arranged above the horizontal conductive structures (H1, H2, H4, H5) and below the fourth conductive structure (L4),
- in which the first source/drain region (3 S/D1) of the third transistor is connected via a fourth contact (K4) to the fourth horizontal conductive structure (H4) and to the fifth conductive structure (L5),
- in which the second source/drain region (2 S/D2) of the second transistor is connected via a fifth contact (K5) to the fifth horizontal conductive structure (H5) and to a sixth conductive structure (L6),
- in which the height of the sixth conductive structure (L6) with regard to an axis perpendicular to the surface (O) corresponds to the height of the fifth conductive structure (L5),
- in which the first source/drain region (4 S/D1) of the fourth transistor is connected to the sixth conductive structure (L6) via a sixth contact (K6),
- in which the second source/drain region (5 S/D2) of the fifth transistor is connected to the first bit line (B1) via a seventh contact (K7), and the second source/drain region (6 S/D2) of the sixth transistor is connected to the second bit line (B2) via an eighth contact (K8),
- in which a first diffusion zone, which is doped by the first conductivity type, within the substrate (S), adjoins the first sidewall (2F1) of the second trench (G2), the second source/drain region (1 S/D1) of the first transistor and the first source/drain region (5 S/D1) of the fifth transistor,
- in which a second diffusion zone (D2), which is doped by the first conductivity type, within the substrate (S), adjoins the first sidewall (2F1) of the second trench (G2), the second source/drain region (2 S/D2) of the second transistor and the first source /drain region (6 S/D1) of the sixth transistor.

4. SRAM cell arrangement according to Claims 1, 2 and/or 3,
- in which, within the substrate (S), heavily doped channel stop regions (C) are arranged on parts of the sidewalls of the trenches which are not adjoined by gate electrodes and diffusion zones,
- in which a first insulation structure (I1) in the form of a strip runs parallel to and between the second trench (G2) and the fourth trench (G4).

5. SRAM cell arrangement according to one of Claims 1 to 4, in which neighbouring memory cells along the first bit line (B1) are arranged mirror-symmetrically with respect to one another with regard to an axis running along a centre line of a first trench (G1) or of a fourth trench (G4).

6. Method for the fabrication of an SRAM cell arrangement,
- in which memory cells each comprising a first transistor, a second transistor, a third transistor, a fourth transistor, a fifth transistor and a sixth transistor are produced,
- in which word lines (W), first bit lines (B1) and second bit lines (B2) are produced,
- in which gate electrodes, first source/drain regions and second source/drain regions are produced,
- in which a first source/drain region (1 S/D1) of the first transistor is connected to a first source/drain region (2 S/D1) of the second transistor and to a first voltage terminal,
- in which a second source/drain region (1 S/D2) of the first transistor is connected to a first source/drain region (3 S/D1) of the third transistor, to a first source/drain region (5 S/D1) of the fifth transistor, to a gate electrode (Ga2) of the second transistor and to a gate electrode (Ga4) of the fourth transistor,
- in which a gate electrode (Ga1) of the first transistor is connected to a second source/drain region (2 S/D2) of the second transistor, to a first source/drain region (4 S/D1) of the fourth transistor, to a gate electrode (Ga3) of the third transistor and to a first source/drain region (6 S/D1) of a sixth transistor,
- in which a second source/drain region (3 S/D2) of the third transistor is connected to a second source/drain region (4 S/D2) of the fourth transistor and to a second voltage terminal,
- in which a second source/drain region (5 S/D2) of the fifth transistor is connected to a first bit line (B1),
- in which a gate electrode (Ga5) of the fifth transistor is connected to a gate electrode (Ga6) of the sixth transistor and to a word line (W),
- in which a second source/drain region (6 S/D2) of the sixth transistor is connected to a second bit line (B2),
- in which the third transistor and the fourth transistor are designed as complementary transistors to the first transistor, to the second transistor, to the fifth transistor and to the sixth transistor,
- in which the six transistors are formed as vertical MOS transistors,
- in which first trenches (G1), second trenches (G2) and fourth trenches (G4), which essentially run parallel to one another, are produced in a substrate (S),
- in which sidewalls of the first trenches (G1), of the second trenches (G2) and of the fourth trenches (G4) are provided with a gate dielectric (Gd),
- in which the first transistor and the second transistor are formed such that they adjoin a second sidewall (1F2) of a first trench (G1),
- in which the fifth transistor and the sixth transistor are formed such that they adjoin a second sidewall (2F2) of a second trench (G2),
- in which the third transistor and the fourth transistor are formed such that they adjoin a first sidewall (4F1) of a fourth trench (G4),
- in which the word line (W) is formed along the second sidewall (2F2) of the second trench (G2),
- in which a first conductive structure (L1), which is connected to the first voltage terminal, is formed along the first trench (G1),
- in which a second conductive structure (L2), which is connected to the second voltage terminal, is produced along the fourth trench (G4),
- in which the first bit line (B1) and, parallel to the first bit line (B1), the second bit line (B2) are formed transversely with respect to the word line (W),
- in which the first source/drain region (1 S/D1)of the first transistor and the first source/drain region (2 S/D1) of the second transistor are connected to the first conductive structure (L1),
- in which the second source/drain region (3 S/D2) of the third transistor and the second source/drain region (4 S/D2) of the fourth transistor are connected to the second conductive structure (L2).

7. Method according to Claim 6, in which, in order to make contact with gate electrodes or conductive structures, horizontal conductive structures are produced outside the first trench (G1), the second trench (G2) and the fourth trench (G4) above a surface (O) of the substrate (S), in such a way that the horizontal conductive structures each adjoin a gate electrode and/or a conductive structure.

8. Method according to Claim 7,
- in which the second source/drain region (1 S/D2) of the first transistor, the second source/drain region (2 S/D2) of the second transistor, the second source/drain region (5 S/D2) of the fifth transistor, the second source/drain region (6 S/D2) of the sixth transistor, the first source/drain region (3 S/D1) of the third transistor and the first source/drain region (4 S/D1) of the fourth transistor are produced by implantation at the surface (O),
- in which the first trenches (G1), the second trenches (G2) and the fourth trenches (G4) are subsequently produced,
- in which the second source/drain region (1 S/D2) of the first transistor, the second source/drain region (2 S/D2) of the second transistor, the second source/drain region (5 S/D2) of the fifth transistor, the second source/drain region (6 S/D2) of the sixth transistor, the first source/drain region (3 S/D1) of the third transistor and the first source/drain region (4 S/D1) of the fourth transistor, the first trenches (G1), the second trenches (G2) and the fourth trenches (G4) are produced in such a way that the second source/drain region (1 S/D2) of the first transistor and the second source/drain region (2 S/D2) of the second transistor adjoin the second sidewall (1F2) of the first trench (G1) and the first sidewall (2F1) of the second trench (G2), and in such a way that the second source/drain region (5 S/D2) of the fifth transistor and the second source/drain region (6 S/D2) of the sixth transistor adjoin the second sidewall (2F2) of the second trench (G2), and in such a way that the first source/drain region (3 S/D1) of the third transistor and the first source/drain region (4 S/D1) of the fourth transistor adjoin the first sidewall (4F1) of the fourth trench (4) [sic],
- in which a first diffusion zone is produced such that it adjoins the second source/drain region (1 S/D2) of the first transistor on the first sidewall (2F1) of the second trench (G2) within the substrate (S) by means of inclined implantation,
- in which a second diffusion zone (D2) is produced such that it adjoins the second source/drain region (2 S/D2) of the second transistor on the first sidewall (2F1) of the second trench (G2) within the substrate (S) by means of inclined implantation,
- in which the first conductive structure (L1) doped by a first conductivity type is produced on a bottom of the first trench (G1) by means of implantation within the substrate (S),
- in which the first source/drain region (5 S/D1) of the fifth transistor and the first source/drain region (6 S/D1) of the sixth transistor are produced by means of implantation on a bottom of the second trench (G2),
- in which [lacuna] second doped conductive structure (L2) doped by a second conductivity type opposite to the first conductivity type is produced by means of implantation on a bottom of the fourth trench (G4),
- in which the deposition, etching back and masked etching of conductive material are effected to produce the word line (W) on the second sidewall (2F2) of the second trench (G2), the gate electrode (Ga1) of the first transistor and the gate electrode (Ga2) of the second transistor on the second sidewall (1F2) of the first trench (G1), a third conductive structure (L3) on the first sidewall (2F1) of the second trench (G2), and the gate electrode (Ga3) of the third transistor and the gate electrode (Ga4) of the fourth transistor on the first sidewall (4F1) of the fourth trench (G4),
- in which a second insulating structure (I2) is produced by depositing insulating material on the surface (O),
- in which a conductive layer (S1) is formed by depositing conductive material on the second insulating structure (I2),
- in which a first horizontal conductive structure (H1), a second horizontal conductive structure (H2), a third horizontal conductive structure, a fourth horizontal conductive structure (H4) and a fifth horizontal conductive structure (H5) are produced by etching conductive material with the aid of a fourteenth mask (M14),
- in which a third insulating structure (13) is produced by depositing and etching back insulating material,
- in which a second contact (K2), which adjoins the second source/drain region (1 S/D2) of the first transistor, a fifth contact (K5), which adjoins the second source/drain region (2 S/D2) of the second transistor, a fourth contact (K4), which adjoins the first source/drain region (3 S/D1) of the third transistor, a sixth contact (K6), which adjoins the first source/drain region (4 S/D1) of the fourth transistor, a fifth conductive structure (L5), which adjoins the second contact (K2) and the fourth contact (K4), and a sixth conductive structure (L6), which adjoins the fifth contact (K5) and the sixth contact (K6), are produced by etching insulating material with the aid of a fifteenth mask (M15) and then depositing conductive material and structuring it with the aid of a sixteenth mask (M16),
- in which a fourth insulating structure (I4) is produced by depositing and etching back insulating material,
- in which a first contact (K1), which adjoins the first horizontal conductive structure (H1), a third contact (K3), which adjoins the third horizontal conductive structure, a seventh contact (K7), which adjoins the second source/drain region (5 S/D2) of the fifth transistor, an eighth contact (K8), which adjoins the second source/drain region (6 S/D2) of the sixth transistor, a fourth conductive structure (L4), which adjoins the first contact (K1) and the third contact (K3), a first bit line (B1), which adjoins the seventh contact (K7), and a second bit line (B2), which adjoins the eighth contact (K8), are produced by etching insulating material with the aid of a seventeenth mask (M17) and then depositing conductive material and structuring it with the aid of an eighteenth mask (M18).

9. Method according to Claims 6, 7 and/or 8,
- in which third trenches (G3) running parallel to one another are produced and filled with insulating material, thereby producing first insulating structures (I1),
- in which the second trench (G2) and the fourth trench (G4) are produced in such a way that they run parallel to the third trench (G3), and that the third trench (G3) lies between them,
- in which heavily doped channel stop regions (C) are produced by means of inclined implantation on parts of the sidewalls of the trenches which are not adjoined by gate electrodes and diffusion zones.

10. Method according to one of Claims 6 to 9, in which neighbouring memory cells along the first bit line (B1) are produced mirror-symmetrically with respect to one another with regard to an axis which runs along a centre line of a first trench (G1) or of a fourth trench (G4).

## Revendications

1. Groupement de cellules RAM statique
- comprenant des cellules de mémoire qui comportent respectivement 6 transistors,
- dans lequel une première zone (1 S/D1) de source/drain d'un premier des transistors est reliée à une première zone (2 S/D1) de source/drain d'un deuxième des transistors et à une première borne de tension,
- dans lequel une deuxième zone (1 S/D2) de source/drain du premier transistor est reliée à une première zone (3 S/D1) de source/drain d'un troisième des transistors, à une première zone (5 S/D1) de source/drain d'un cinquième des transistors, à une électrode (Ga2) de grille du deuxième transistor et à une électrode (Ga4) de grille d'un quatrième des transistors,
- dans lequel une électrode (Ga1) de grille du premier transistor est reliée à une deuxième zone (2 S/D2) de source/drain du deuxième transistor, à une première zone (4 S/D1) de source/drain du quatrième transistor, à une électrode (Ga3) de grille du troisième transistor et à une première zone (6 S/D1) de source/drain d'un sixième des transistors,
- dans lequel une deuxième zone (3 S/D2) de source/drain du troisième transistor est reliée à une deuxième zone (4 S/D2) de source/drain du quatrième transistor et à une deuxième borne de tension,
- dans lequel une deuxième zone (5 S/D2) de source/drain du cinquième transistor est reliée à une première ligne (B1) de bits,
- dans lequel une électrode (Ga5) de grille du cinquième transistor est reliée à une électrode (Ga6) de grille du sixième transistor et à une ligne (W) de mots,
- dans lequel une deuxième zone (6 S/D2) de source/drain du sixième transistor est reliée à une deuxième ligne (B2) de bits,
- dans lequel le troisième transistor et le quatrième transistor sont complémentaires du premier transistor, du deuxième transistor, du cinquième transistor et du sixième transistor,
- dans lequel les six transistors sont constitués sous la forme de transistors MOS verticaux,
- dans lequel le premier transistor et le deuxième transistor sont placés sur un deuxième flanc (1F2) d'un premier sillon (G1) qui s'étend dans un substrat (S),
- dans lequel le cinquième transistor et le sixième transistor sont disposés sur un deuxième flanc (2F2) d'un deuxième sillon (G2) qui s'étend dans le substrat (S) et parallèlement au premier sillon (G1),
- dans lequel le troisième transistor et le quatrième transistor sont disposés sur un premier flanc (4F1) d'un quatrième sillon (G4) qui s'étend dans le substrat (S) et parallèlement au deuxième sillon (G2),
- dans lequel la ligne (W) de mots s'étend le long du deuxième flanc (2F2) du deuxième sillon (G2),
- dans lequel une première structure (L1) conductrice est reliée à la première borne de tension et une deuxième structure (L2) conductrice à la deuxième borne de tension,
- dans lequel la première structure (L1) conductrice s'étend le long du premier sillon (G1) et la deuxième structure (L2) conductrice le long du quatrième sillon (G4),
- dans lequel la première ligne (B1) de bits et la deuxième ligne (B2) de bits s'étendent transversalement à la ligne (W) de mots et parallèlement entre elles,
- dans lequel la première zone (1 S/D1) de source/drain du premier transistor et la première zone (2 S/D1) de source/drain du deuxième transistor sont reliées à la première structure (L1) conductrice,
- dans lequel la deuxième zone (3 S/D2) de source/drain du troisième transistor et la deuxième zone (4 S/D2) de source/drain du quatrième transistor sont reliées à la deuxième structure (L2) conductrice.

2. Groupement de cellules de mémoire RAM statique suivant la revendication 1, dans lequel des électrodes de grille ou des structures conductrices sont voisines de structures conductrices horizontales qui sont disposées à l'extérieur du premier sillon (G1), du deuxième sillon (G2), et du quatrième sillon (G4) au-dessus d'une surface (O) du substrat (S) et par lesquelles elles sont mises en contact.

3. Groupement de cellules de mémoire RAM statique suivant la revendication 2,
- dans lequel le premier sillon (G1) et le deuxième sillon (G2) sont disposés dans une première cuvette (Wa1) du substrat (S) dopée suivant un deuxième type de conductivité,
- dans lequel le quatrième sillon (G4) est disposé dans une deuxième cuvette (Wa2) du substrat (S) dopée suivant un type de conductivité opposé au deuxième type de conductivité,
- dans lequel la première structure (L1) conductrice est voisine au sein du substrat d'un fond du premier sillon (G1) et est dopée suivant le premier type de conductivité, et la deuxième structure conductrice est voisine au sein du substrat (S) d'un fond du quatrième sillon (G4) et est dopée suivant le deuxième type de conductivité,
- dans lequel la première zone (1 S/D1) de source/drain du premier transistor et la première zone (2 S/D1) de source/drain du deuxième transistor font partie de la première structure (L1) conductrice,
- dans lequel la deuxième zone (3 S/D2) de source/drain du troisième transistor et la deuxième zone (4 S/D2) de source/drain du quatrième transistor font partie de la deuxième structure (L2) conductrice,
- dans lequel il est disposé des parties d'une deuxième structure (I2) isolante entre des structures (H1, H2, H4, H5) conductrices horizontales et la surface (O),
- dans lequel l'électrode (Ga1) de grille du premier transistor, l'électrode (Ga2) de grille du deuxième transistor, l'électrode (Ga3) de grille du troisième transistor, l'électrode (Ga4) de grille du quatrième transistor, l'électrode (Ga5) de grille du cinquième transistor et l'électrode (Ga6) de grille du sixième transistor sont constituées sous la forme d'espaceur,
- dans lequel l'électrode (Ga1) de grille du premier transistor est voisine d'une première structure (H1) conductrice horizontale, l'électrode (Ga2) de grille du deuxième transistor est voisine d'une deuxième structure (H2) conductrice horizontale, l'électrode (Ga3) de grille du troisième transistor est voisine d'une troisième structure conductrice horizontale et l'électrode (Ga4) de grille du quatrième transistor est voisine d'une quatrième structure (H4) conductrice horizontale,
- dans lequel la ligne (W) de mots est constituée sous la forme d'espaceur sur le deuxième flanc (2F2) du deuxième sillon (G2),
- dans lequel l'électrode (Ga5) de grille du cinquième transistor et l'électrode (Ga6) de grille du sixième transistor font partie de la ligne (W) de mots,
- dans lequel une troisième structure (L3) conductrice est constituée sous la forme d'un espaceur sur le premier flanc (2F1) du deuxième sillon (G2),
- dans lequel la troisième structure (L3) conductrice est voisine de la première structure (H1) conductrice horizontale et de la cinquième structure (H5) conductrice horizontale,
- dans lequel le deuxième flanc (1F2) du premier sillon (G1), le premier flanc (2F1) du deuxième sillon (G2), le deuxième flanc (2F2) du deuxième sillon (G2) et le premier flanc (4F1) du quatrième sillon (G4) sont munis d'un diélectrique (Gd) de grille,
- dans lequel la deuxième zone (1 S/D2) de source/drain du premier transistor et la deuxième zone (2 S/D2) de source/drain du deuxième transistor sont voisines de la surface (O) ainsi que du deuxième flanc (1F2) du premier sillon (G1) et du premier flanc (2F1) du deuxième sillon (G2),
- dans lequel la première zone (3 S/D1) de source/drain du troisième transistor et la première zone (4 S/D1) de source/drain du quatrième transistor sont voisines de la surface (O) ainsi que du premier flanc (4 F1) du quatrième transistor (G4),
- dans lequel la deuxième zone (5 S/D2) de source/drain du cinquième transistor et la deuxième zone (6 S/D2) de source/drain du sixième transistor sont voisines de la surface (O) ainsi que du deuxième flanc (2F2) du deuxième sillon (G2),
- dans lequel la première structure (H1) conductrice horizontale est reliée à une quatrième structure (L4) conductrice par un premier contact (K1),
- dans lequel la troisième structure conductrice horizontale est reliée à la quatrième structure (L4) conductrice par un troisième contact (K3),
- dans lequel la quatrième structure (L4) conductrice est disposée au-dessus des deuxièmes structures (H1, H2, H4, H5) conductrices horizontales,
- dans lequel la deuxième zone (1 S/D2) de source/drain du premier transistor est reliée par un deuxième contact (K2) à la deuxième structure (H2) conductrice horizontale et à une cinquième structure (L5) conductrice,
- dans lequel la cinquième structure (L5) conductrice est disposée au-dessus des structures (H1, H2, H4, H5) conductrices horizontales et en dessous de la quatrième structure (L4) conductrice,
- dans lequel la première zone (3 S/D1) de source/drain du troisième transistor est reliée par un quatrième contact (K4) à la quatrième structure (H4) conductrice horizontale et à la cinquième structure (L5) conductrice,
- dans lequel la deuxième zone (2 S/D2) de source/drain du deuxième transistor est reliée par un cinquième contact (K5) à la cinquième structure (H5) conductrice horizontale et à une sixième structure (L6) conductrice,
- dans lequel le niveau de la sixième structure (L6) conductrice suivant un axe perpendiculaire à la surface (O) correspond au niveau de la cinquième structure (L5) conductrice,
- dans lequel la première zone (4 S/D1) de source/drain du quatrième transistor est reliée par un sixième contact (K6) à la sixième structure (L6) conductrice,
- dans lequel la deuxième zone (5 S/D2) de source/drain du cinquième transistor est reliée par un septième contact (K7) à la première ligne (B1) de bits, et la deuxième zone (6 S/D2) de source/drain du sixième transistor est reliée par un huitième contact (K8) à la deuxième ligne (B2) de bits,
- dans lequel une première zone de diffusion dopée suivant le premier type de conductivité est voisine au sein du substrat (S) du premier flanc (2F1) du deuxième sillon (G2), de la deuxième zone (1 S/D1) de source/drain du premier transistor et de la première zone (5 S/D1) de source/drain du cinquième transistor,
- dans lequel une deuxième zone (D2) de diffusion dopée suivant le premier type de conductivité est voisine au sein du substrat (S) du premier flanc (2F1) du deuxième sillon (G2), de la deuxième zone (2 S/D2) de source/drain du deuxième transistor et de la première zone (6 S/D1) de source/drain du sixième transistor.

4. Groupement de cellules de mémoire RAM statique suivant les revendications 1, 2 et/ou 3,
- dans lequel il est disposé, au sein du substrat (S), sur des parties des flancs des sillons dont ne sont pas voisines des électrodes de grille et des zones de diffusion, des zones (C) de Channel-Stop qui sont très dopées,
- dans lequel une première structure (I1) d'isolement en forme de bande s'étend parallèlement au deuxième sillon (G2) et au quatrième sillon (G4) et entre ceux-ci.

5. Groupement de cellules de mémoire RAM statique suivant l'une des revendications 1 à 4, dans lequel des cellules de mémoire voisines le long de la première ligne (B1) de bits sont disposées symétriques les unes des autres comme en un miroir par rapport à un axe qui s'étend le long d'une ligne médiane d'un premier sillon (G1) ou d'un quatrième sillon (G4).

6. Procédé de fabrication d'un groupement de cellules de mémoires RAM statique,
- dans lequel on produit des cellules de mémoire qui comprennent respectivement un premier transistor, un deuxième transistor, un troisième transistor, un quatrième transistor, un cinquième transistor et un sixième transistor,
- dans lequel on produit des lignes (W) de mots, des premières lignes (B1) de bits et des deuxièmes lignes (B2) de bits,
- dans lequel on produit des électrodes de grille, des premières zones de source/drain et des deuxièmes zones de source/drain,
- dans lequel on relie une première zone (1 S/D1) de source/drain du premier transistor à une première zone (2 S/D1) de source/drain du deuxième transistor et à une borne de tension,
- dans lequel on relie une deuxième zone (1 S/D2) de source/drain du premier transistor à une première zone (3 S/D1) de source/drain du troisième transistor, à une première zone (5 S/D1) de source/drain du cinquième transistor, à une électrode (Ga2) de grille du deuxième transistor et à une électrode (Ga4) de grille du quatrième transistor,
- dans lequel on relie une électrode (Ga1) de grille du premier transistor à une deuxième zone (2 S/D2) de source/drain du deuxième transistor, à une première zone (4 S/D1) de source/drain du quatrième transistor, à une électrode (Ga3) de grille du troisième transistor et à une première zone (6 S/D1) de source/drain d'un sixième transistor,
- dans lequel on relie une deuxième zone (3 S/D2) de source/drain du troisième transistor à une deuxième zone (4 S/D2) de source/drain du quatrième transistor et à une deuxième borne de tension,
- dans lequel on relie une deuxième zone (5 S/D2) de source/drain du cinquième transistor à une première ligne (B1) de bits,
- dans lequel on relie une électrode (Ga5) de grille du cinquième transistor à une électrode (Ga6) de grille du sixième transistor et à une ligne (W) de mots,
- dans lequel on relie une deuxième zone (6 S/D2) de source/drain du sixième transistor à une deuxième ligne (B2) de bits,
- dans lequel on constitue le troisième transistor et le quatrième transistor sous la forme de transistors complémentaires du premier transistor, du deuxième transistor, du cinquième transistor et du sixième transistor,
- dans lequel on forme les six transistors sous la forme de transistors MOS verticaux,
- dans lequel on produit, dans un substrat (S), des premiers sillons (G1), des deuxièmes sillons (G2) et des quatrièmes sillons (G4) qui s'étendent sensiblement parallèlement entre eux,
- dans lequel on munit des flancs des premiers sillons (G1), des deuxièmes sillons (G2) et des quatrièmes sillons (G4) d'un diélectrique (Gd) de grille,
- dans lequel on forme le premier transistor et le deuxième transistor au voisinage du deuxième flanc (1F2) d'un premier sillon (G1),
- dans lequel on forme le cinquième transistor et le sixième transistor au voisinage d'un deuxième flanc (2F2) d'un deuxième sillon (G2),
- dans lequel on forme le troisième transistor et le quatrième transistor au voisinage d'un premier flanc (4F1) d'un quatrième sillon (G4),
- dans lequel on forme la ligne (W) de mots le long du deuxième flanc (2F2) du deuxième sillon (G2),
- dans lequel on forme, le long du premier sillon (G1), une première structure (L1) conductrice que l'on relie à la première borne de tension,
- dans lequel on produit le long du quatrième sillon (G4) une deuxième structure (L2) conductrice que l'on relie à la deuxième borne de tension,
- dans lequel on forme, transversalement à la ligne (W) de mots, la première ligne (B1) de bits et, parallèlement à la première ligne (B1) de bits, la deuxième ligne (B2) de bits,
- dans lequel on relie la première zone (1 S/D1) de source/drain du premier transistor et la première zone (2 S/D1) de source/drain du deuxième transistor à la première structure (L1) conductrice,
- dans lequel on relie la deuxième zone (3 S/D2) de source/drain du troisième transistor et la deuxième zone (4 S/D2) de source/drain du quatrième transistor à la deuxième structure (L2) conductrice.

7. Procédé suivant la revendication 6, dans lequel, pour établir le contact d'électrodes de grille ou de structures conductrices, on produit à l'extérieur du premier sillon (G1), du deuxième sillon (G2) et du quatrième sillon (G4), au-dessus d'une surface (O) de substrat (S), des structures conductrices horizontales, de façon à ce que les structures conductrices horizontales soient voisines respectivement d'une électrode de grille ou/et d'une structure conductrice.

8. Procédé suivant la revendication 7,
- dans lequel on produit à la surface (O), par implantation, la deuxième zone (1 S/D2) de source/drain du premier transistor, la deuxième zone (2 S/D2) de source/drain du deuxième transistor, la deuxième zone (5 S/D2) de source/drain du cinquième transistor, la deuxième zone (6 S/D2) de source/drain du sixième transistor, la première zone (3 S/D1) de source/drain du troisième transistor et la première zone (4 S/D1) de source/drain du quatrième transistor,
- dans lequel on produit ensuite les premiers sillons (G1), les deuxièmes sillons (G2) et les quatrièmes sillons (G4),
- dans lequel on produit la deuxième zone (1 S/D2) de source/drain du premier transistor, la deuxième zone (2 S/D2) de source/drain du deuxième transistor, la deuxième zone (5 S/D2) de source/drain du cinquième transistor, la deuxième zone (6 S/D2) de source/drain du sixième transistor, la première zone (3 S/D1) de source/drain du troisième transistor et la première zone (4 S/D1) de source/drain du quatrième transistor, les premiers sillons (G1), les deuxièmes sillons (G2) et les quatrièmes sillons (G4), de façon à ce que la deuxième zone (1 S/D2) de source/drain du premier transistor et la deuxième zone (2 S/D2) de source/drain du deuxième transistor soient voisines du deuxième flanc (1F2) du premier sillon (G1) et du premier flanc (2F1) du deuxième sillon (G2), et de façon à ce que la deuxième zone (5 S/D2) de source/drain du cinquième transistor et la deuxième zone (6 S/D2) de source/drain du sixième transistor soient voisines du deuxième flanc (2F2) du deuxième sillon (G2), et de façon à ce que la première zone (3 S/D1) de source/drain du troisième transistor et la première zone (4 S/D1) de source/drain du quatrième transistor soient voisines du premier flanc (4F1) du quatrième sillon (4),
- dans lequel on produit, par implantation inclinée, une première région de diffusion voisine de la deuxième zone (1 S/D2) de source/drain du premier transistor sur le premier flanc (2F1) du deuxième sillon (G2) au sein du substrat (S),
- dans lequel on produit, par implantation inclinée, une deuxième région (D2) de diffusion voisine de la deuxième zone (2 S/D2) de source/drain du deuxième transistor sur le premier flanc (2F1) du deuxième sillon (G2) au sein du substrat (S)
- dans lequel on produit, par implantation, au sein du substrat (S) la première structure (L1) conductrice dopée suivant le premier type de conductivité sur un fond du premier sillon (G1),
- dans lequel on produit, par implantation sur un fond du deuxième sillon (G2), la première zone (5 S/D1) de source/drain du cinquième transistor et la première zone (6 S/D1) de source/drain du sixième transistor,
- dans lequel on produit, par implantation sur un fond du quatrième sillon (G4), la deuxième structure (L2) conductrice dopée suivant un deuxième type de conductivité opposé au premier type de conductivité,
- dans lequel on produit par dépôt, attaque en retrait et attaque masquée de matériau conducteur sur le deuxième flanc (2F2) du deuxième sillon (G2) la ligne (W) de mots, sur le deuxième flanc (1F2) du premier sillon(G1) l'électrode (Ga1) de grille du premier transistor et l'électrode (Ga2) de grille du deuxième transistor, sur le premier flanc (2F1) du deuxième sillon (G2) une troisième structure (L3) productrice et sur le premier flanc (4F1) du quatrième sillon (G4) l'électrode (Ga3) de grille du troisième transistor et l'électrode (Ga4) de grille du quatrième transistor,
- dans lequel on produit, par dépôt de matériau isolant sur la surface (O), une deuxième structure (12) isolante,
- dans lequel on forme une couche (S1) conductrice par dépôt de matériau conducteur sur la deuxième structure (12) isolante,
- dans lequel on produit, par attaque de matériau conducteur à l'aide d'un quatorzième masque (M14), une première structure (H1) conductrice horizontale, une deuxième structure (H2) conductrice horizontale, une troisième structure conductrice horizontale, une quatrième structure (H4) conductrice horizontale et une cinquième structure (H5) conductrice horizontale,
- dans lequel, par dépôt et attaque en retour de matériau isolant, on produit une troisième structure (13) isolante,
- dans lequel on produit un deuxième contact (K2) qui est voisin de la deuxième zone (1 S/D2) de source/drain du premier transistor, un cinquième contact (K2) qui est voisin de la deuxième zone (2 S/D2) de source/drain du deuxième transistor, un quatrième contact (K4) qui est voisin de la première zone (3 S/D1) de source/drain du troisième transistor, un sixième contact (K6) qui est voisin de la première zone (4 S/D1) de source/drain du quatrième transistor, une cinquième structure (L5) conductrice qui est voisine du deuxième contact (K2) et du quatrième contact (K4) et une sixième structure (L6) conductrice qui est voisine du cinquième contact (K5) et du sixième contact (K6), en attaquant du matériau isolant à l'aide d'un quinzième masque (M15) et en déposant ensuite du matériau conducteur et en structurant à l'aide d'un seizième masque (M16),
- dans lequel on produit, par dépôt et attaque en retour de matériau isolant, une quatrième structure (I4) isolante,
- dans lequel on produit un premier contact (K1) qui est voisin de la première structure (H1) conductrice horizontale, un troisième contact (K3) qui est voisin de la troisième structure conductrice horizontale, un septième contact (K7) qui est voisin de la deuxième zone (5 S/D2) de source/drain du cinquième transistor, un huitième contact (K8) qui est voisin de la deuxième zone (6 S/D2) de source/drain du sixième transistor, une quatrième structure (L4) conductrice qui est voisine du premier contact (K1) et du troisième contact (K3), une première ligne (B1) de bits qui est voisine du septième contact (K7) et une deuxième ligne (B2) de bits qui est voisine du huitième contact (K8), en attaquant du matériau isolant à l'aide d'un dix-septième masque (M17) et en déposant ensuite du matériau conducteur et en le structurant à l'aide d'un dix-huitième masque (M18).

9. Procédé suivant les revendications 6, 7 et/ou 8,
- dans lequel on produit des troisièmes sillons (G3) s'étendant parallèles entre eux et on les emplit de matériau isolant, ce qui produit de premières structures (11) isolantes,
- dans lequel on produit les deuxièmes sillons (G2) et les quatrièmes sillons (G4) de façon à ce qu'ils soient parallèles aux troisièmes sillons (G3) et de façon à ce que les troisièmes sillons (G3) se trouvent entre eux,
- dans lequel on produit, par implantation inclinée, des zones (C) de Channel-Stop très dopées sur des parties des flancs des sillons dont des électrodes de grille et des régions de diffusion ne sont pas voisines.

10. Procédé suivant l'une des revendications 6 à 9, dans lequel on produit, le long de la première ligne (B1) de bits, des cellules de mémoire voisines qui sont symétriques comme en un miroir les unes des autres par rapport à un axe qui s'étend le long d'une ligne médiane d'un premier sillon (G1) ou d'un quatrième sillon (G4).
